# EUROPEAN PATENT SPECIFICATION

(11) **EP 4 349 814 B1**
(45) Date of publication and mention of the grant of the patent: **09.07.2025**
(21) Application number: 22811314.8
(22) Date of filing: 24.05.2022
(51) Int. Cl.: C07F 15/00, C09K 11/06, H10K 85/30, H10K 50/11

(54) **IRIDIUM COMPLEX COMPOUND, COMPOSITION CONTAINING IRIDIUM COMPLEX COMPOUND, ORGANIC ELECTROLUMINESCENT ELEMENT AND METHOD FOR PRODUCING SAME**
IRIDIUMKOMPLEXVERBINDUNG, ZUSAMMENSETZUNG MIT IRIDIUMKOMPLEXVERBINDUNG, ORGANISCHES ELEKTROLUMINESZENZELEMENT UND HERSTELLUNGSVERFAHREN DAFÜR
COMPOSÉ COMPLEXE D'IRIDIUM, COMPOSITION CONTENANT UN COMPOSÉ COMPLEXE D'IRIDIUM, ÉLÉMENT ÉLECTROLUMINESCENT ORGANIQUE ET SON PROCÉDÉ DE PRODUCTION

(30) Priority: 25.05.2021 JP 2021087775
(43) Date of publication of application: 10.04.2024
(73) Proprietor: Mitsubishi Chemical Corporation, Chiyoda-ku Tokyo 100-8251 (JP)
(72) Inventor: NAGAYAMA, Kazuhiro, Tokyo 100-8251 (JP); OKABE, Kazuki, Tokyo 100-8251 (JP); NISHIO, Itsumi, Tokyo 100-8251 (JP); NARA, Mayuko, Tokyo 100-8251 (JP)
(74) Representative: Hoffmann Eitle
(86) International application number: PCT/JP2022/021220
(87) International publication number: WO 2022/250044

(56) References cited:
- WO-A1-2016/194784
- WO-A1-2019/107467
- WO-A1-2020/230811
- JP-A- 2015 515 463

## Description

### Technical Field

The present invention relates to an iridium complex compound and an iridium complex compound-containing the composition, and particularly relates to an iridium complex compound useful as a material for a light-emitting layer of an organic electroluminescent element (hereinafter also referred to as an "organic EL element"). The present invention also relates to an iridium complex compound-containing composition containing the iridium complex compound. The present invention also relates to an organic electroluminescent element containing the iridium complex compound, and a method for manufacturing the same.

### Background Art

Various electronic devices, in which organic electroluminescent elements such as organic EL illuminators and organic EL displays are used, have been put to practical use. Organic electroluminescent elements, which consume little power because of their low applied voltage and which can also perform light emission of three primary colors, have been put to practical use not only in large-sized display monitors but also in medium- and small-sized displays typified by cellular phones and smartphones.

Organic electroluminescent elements are produced by stacking a plurality of layers such as a light-emitting layer, a charge injection layer, and a charge transport layer. Currently, many of the organic electroluminescent elements are produced by depositing organic materials under vacuum. However, vacuum deposition methods involve complex deposition processes and are poor in productivity. It is very difficult to provide a large-sized panel for an illuminator or a display by using an organic electroluminescent element produced by a vacuum deposition method.

Consequently, in recent years, wet film-forming methods (application methods) have been intensively studied as processes for efficiently producing an organic electroluminescent element that can be used in a large-sized display or illuminator. Wet film-forming methods, compared with vacuum deposition methods, have the advantage of being able to readily form stable layers. Therefore, wet film-forming methods are expected to be applied to mass production of displays and illumination devices and to large-sized devices.

To produce an organic electroluminescent element by a wet film-forming method, materials used all need to smoothly dissolve in an organic solvent and to be usable in the form of an ink. When the material to be used is poorly soluble in a solvent, the material may deteriorate before use because an operation such as heating for a long period of time is required. Furthermore, when the uniform state cannot be maintained for a long time in a solution state, the material will precipitate from the solution, making it impossible to form a film using an inkjet device or the like.

In other words, the materials used in the wet film formation method are required to have solubility in two senses: to dissolve quickly in an organic solvent and to maintain a uniform state without precipitating after dissolution.

On the other hand, the performance required for organic electroluminescent elements includes improved luminous efficiency and longer operating lifetime. If these requirements cannot be satisfied at the same time, it will be difficult to use it as an organic EL display material.

As described above, in the light-emitting materials used in organic EL displays, the following properties 1 to 3 are required.
1. It is highly soluble in solvents and maintains a uniform state as an ink for a long period of time without reprecipitation.
2. It has high luminous efficiency.
3. It has a long operating lifetime when used as an organic EL element.

In particular, with respect to the property 1, the concentration of the light-emitting material in the light-emitting layer has been increased in order to prolong the operating lifetime, and as a result, the development of a light-emitting material with higher solubility has been eagerly awaited.

Iridium complex compounds that utilize phosphorescence emission have been used as light-emitting materials that have high luminous efficiency and can extend operating lifetime. Specifically, iridium complex compounds having phenyl-pyridine type ligands as shown in Patent Literature 1 to 3 are known. Patent Literature 1 discloses an iridium complex compound having a structure similar to that of the iridium complex compound of the present invention. However, in the iridium complex compound disclosed in Patent Literature 1, the group corresponding to Ar in the formula (1) of the present invention is a phenyl group, a biphenyl group or a terphenyl group, and the number of connected benzene rings is less than the iridium complex compound of the present invention. Also, it is not one in which a plurality of meta-phenylene groups are connected.

Although Patent Literatures 2 and 3 also disclose a wide range of iridium complex compounds, they do not suggest the iridium complex compound of the present invention.
[Patent Literature 1] International Publication No. 2013/142634
[Patent Literature 2] International Publication No. 2004/026886
[Patent Literature 3] International Publication No. 2020/230811

The compound disclosed in Patent Literature 1 has low solubility in solvents and is difficult to form into a highconcentration ink, so it is not possible to increase the concentration of the light-emitting material in the light-emitting layer to extend the life of the device.

Among the compounds disclosed in Patent Literatures 2 and 3, those having highly flexible substituents such as alkyl groups or aralkyl groups are presumed to have high solvent solubility. However, since these substituents form an insulating portion in the light-emitting layer, the driving voltage of the device is increased. In addition, these substituents cause decomposition accompanied by cleavage of C-C bonds and C-H bonds, adversely affecting the driving life of the device.

Documents WO 2019/107467 A1 and WO 2016/194784 A1 disclose iridium complex compounds having a phenyl-pyridine-type ligands and their use as a material for a light-emitting layer of an organic electroluminescent element.

### Summary of invention

An object of the present invention is to provide an iridium complex compound and an iridium complex compound-containing composition, which have high solubility in solvents, and can further improve the luminous efficiency and driving life of the device.

Another object of the present invention is to provide an organic electroluminescence device using the iridium complex compound, the device being excellent in luminous efficiency and operating lifetime.

The inventors have found that an iridium complex compound having a specific chemical structure has high solubility in solvents, and contributes to improving the luminous efficiency and operating lifetime of the device.

The present invention concerns the following.
[1] An iridium complex compound denoted by a formula (1) below.

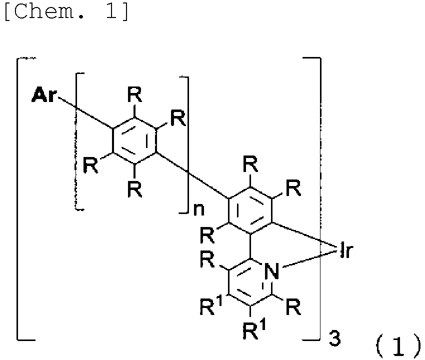

[In the formula (1), Ir represents an iridium atom. n is 1 or 2. Ar is a structure represented by a formula (2) below.

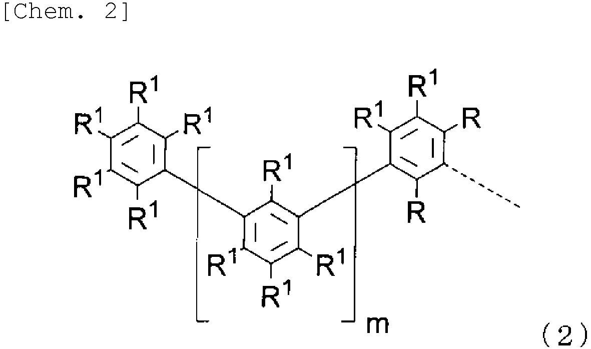

In the formula (2), a dashed line represents a bond of Ar in the formula (1). m is an integer from m=n+1 to n+5.

Substituents R in the formulas (1) and (2) are each independently a hydrogen atom, D or F.

Substituents R¹ in the formulas (1) and (2) are each independently a hydrogen atom, D, F, Cl, Br, I, -N(R')₂, - CN, -NO₂, -OH, -COOR', -C(=O)R', -C(=O)NR', -P(=O)(R')₂, - S(=O)R', -S(=O)₂R', -OS(=O)₂R', a linear, branched or cyclic alkyl group having 1 to 6 carbon atoms, a linear or branched alkoxy group having 1 to 4 carbon atoms, a linear, branched or cyclic alkylthio group having 1 to 4 carbon atoms, a linear or branched alkenyl group having 2 to 4 carbon atoms, a linear or branched alkynyl group having 2 to 4 carbon atoms, an aromatic group having 5 to 60 carbon atoms, a heteroaromatic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms . These groups may be substituted with one or more R' other than a hydrogen atom.

Each R' is independently a hydrogen atom, D, F, -CN, a linear, branched or cyclic alkyl group having 1 to 6 carbon atoms, a linear or branched alkenyl group having 2 to 4 carbon atoms, or a linear or branched alkynyl group having 2 to 4 carbon atoms.]

[2] The iridium complex compound according to [1], wherein the substituents R and R¹ in the formulas (1) and (2) are a hydrogen atom or D.

[3] An iridium complex compound-containing composition comprising the iridium complex compound according to [1] or [2].

[4] The iridium complex compound-containing composition according to [3], further comprising an iridium complex compound represented by a formula (3) below.

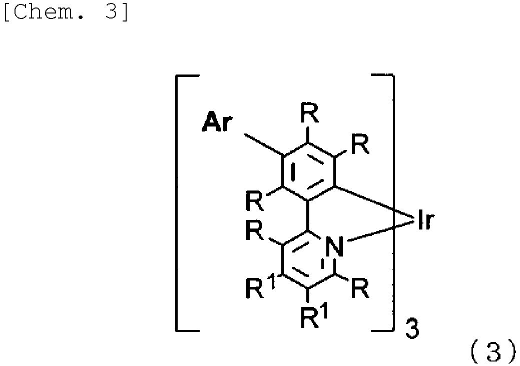

[In the Formula (3), Ir represents an iridium atom. Ar is a structure represented by a formula (2) below.

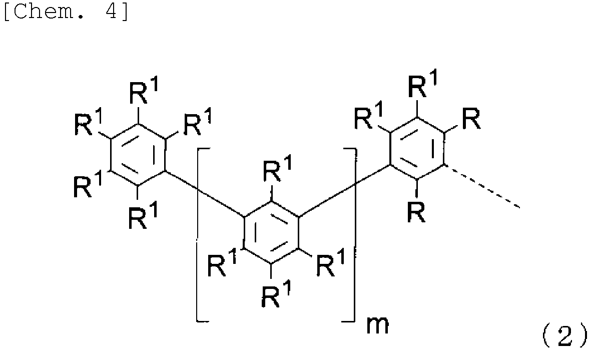

In the formula (2), a dashed line represents a bond of Ar in the formula (3). m is an integer from 1 to 6.

Substituents R in the formulas (3) and (2) are each independently a hydrogen atom, D or F.

Substituents R¹ in the formulas (3) and (2) are each independently a hydrogen atom, D, F, Cl, Br, I, -N(R')₂, - CN, -NO₂, -OH, -COOR', -C(=O)R', -C(=O)NR', -P(=O)(R')₂, - S(=O)R', -S(=O)₂R', -OS(=O)₂R', a linear, branched or cyclic alkyl group having 1 to 6 carbon atoms, a linear or branched alkoxy group having 1 to 4 carbon atoms, a linear, branched or cyclic alkylthio group having 1 to 4 carbon atoms, a linear or branched alkenyl groups having 2 to 4 carbon atoms, a linear or branched alkynyl group having 2 to 4 carbon atoms, an aromatic group having 5 to 60 carbon atoms, a heteroaromatic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms . These groups may be substituted with one or more R' other than a hydrogen atom.

Each R' is independently a hydrogen atom, D, F, -CN, a linear, branched or cyclic alkyl group having 1 to 6 carbon atoms, a linear or branched alkenyl group having 2 to 4 carbon atoms, or a linear or branched alkynyl group having 2 to 4 carbon atoms.]

[5] An organic electroluminescent element having at least an anode, a cathode, and at least one organic layer between the anode and the cathode on a substrate,
wherein at least one of the organic layers is a light-emitting layer, and
the light-emitting layer comprises the iridium complex compound according to [1] or [2].

[6] The organic electroluminescence element according to [5], wherein the light-emitting layer further comprises an iridium complex compound represented by a formula (3) below.

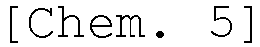

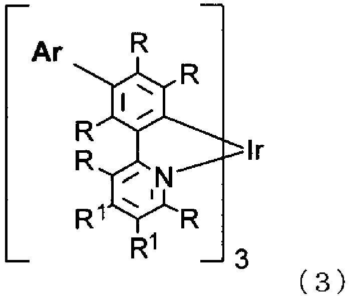

[In the Formula (3), Ir represents an iridium atom. Ar is a structure represented by a formula (2) below.

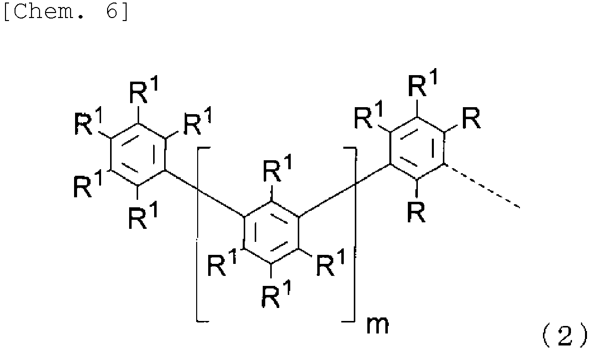

In the formula (2), a dashed line represents a bond of Ar in the formula (3). m is an integer from 1 to 6.

Substituents R in the formulas (3) and (2) are each independently a hydrogen atom, D or F.

Substituents R¹ in the formulas (3) and (2) are each independently a hydrogen atom, D, F, Cl, Br, I, -N(R')₂, - CN, -NO₂, -OH, -COOR', -C(=O)R', -C(=O)NR', -P(=O)(R')₂, - S(=O)R', -S(=O)₂R', -OS(=O)₂R', a linear, branched or cyclic alkyl group having 1 to 6 carbon atoms, a linear or branched alkoxy group having 1 to 4 carbon atoms, a linear, branched or cyclic alkylthio group having 1 to 4 carbon atoms, a linear or branched alkenyl groups having 2 to 4 carbon atoms, a linear or branched alkynyl group having 2 to 4 carbon atoms, an aromatic group having 5 to 60 carbon atoms, a heteroaromatic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms . These groups may be substituted with one or more R' other than a hydrogen atom.

Each R' is independently a hydrogen atom, D, F, -CN, a linear, branched or cyclic alkyl group having 1 to 6 carbon atoms, a linear or branched alkenyl group having 2 to 4 carbon atoms, or a linear or branched alkynyl group having 2 to 4 carbon atoms.]

[7] The iridium complex compound-containing composition according to [3] or [4], further comprising a solvent.

[8] A method for manufacturing an organic electroluminescence element having at least an anode, a cathode, and at least one organic layer between the anode and the cathode on a substrate,
wherein at least one of the organic layers is a light-emitting layer,
the light-emitting layer is formed by wet film-forming of the iridium complex compound-containing composition according to [7].

[9] An organic electroluminescence element manufactured by the method according to [8].

[10] A display device comprising the organic electroluminescent element according to [6] or [9].

[11] An illumination device comprising the organic electroluminescent element according to [6] or [9]. Advantageous Effects of Invention

According to the present invention, an iridium complex compound and an iridium complex compound-containing composition that have high solubility in a solvent and can further improve the luminous efficiency and operating lifetime when used in an organic EL element are provided. According to the present invention, an organic electroluminescence element excellent in luminous efficiency and operating lifetime is provided by using this iridium complex compound.

### Brief Description of Drawings

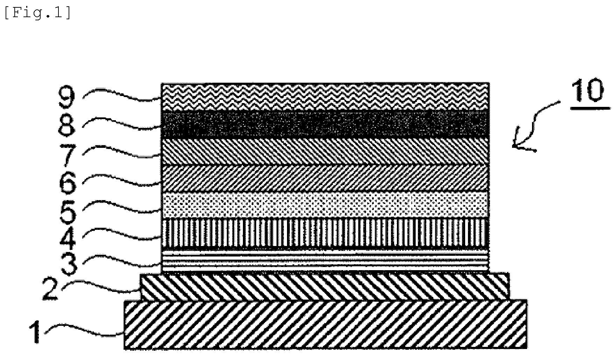

[Fig. 1] Fig. 1 is a sectional view schematically illustrating an example of a structure of an organic electroluminescent element of the present invention. Description of Embodiments

Embodiments of the present invention will now be described in detail, but the present invention is not limited to the following embodiments and can be practiced with various modifications within the scope of the invention.

As used herein, the term "aromatic ring" refers to an "aromatic hydrocarbon ring" and is distinct from a "heteroaromatic ring" which includes a heteroatom as a ring constituting atom. Similarly, the term "aromatic group" refers to an "aromatic hydrocarbon ring group", and the term "heteroaromatic group" refers to a "heteroaromatic ring group" .

The terms "solution medium" and "solvent" are synonymous.

### [Iridium complex compound]

An iridium complex compound of the present invention is an iridium complex compound represented by formula (1) below.

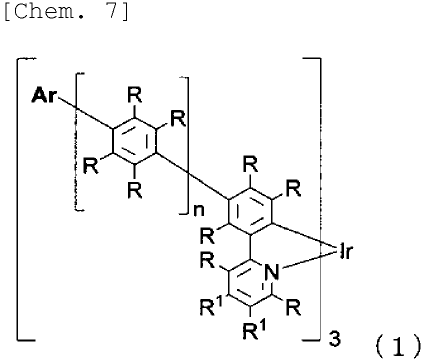

[In the formula (1), Ir represents an iridium atom. n is 1 or 2. Ar is a structure represented by a formula (2) below.

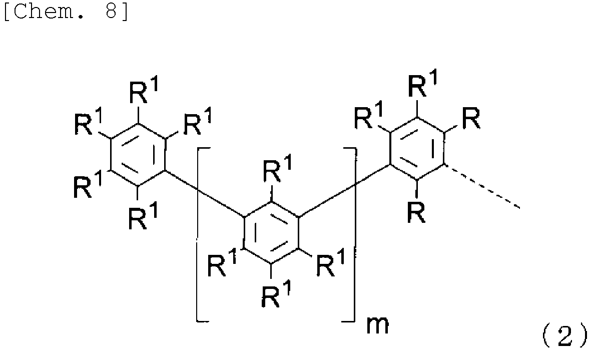

In the formula (2), a dashed line represents a bond of Ar in the formula (1). m is an integer from m=n+1 to n+5.

Substituents R in the formulas (1) and (2) are each independently a hydrogen atom, D or F.

Substituents R¹ in the formulas (1) and (2) are each independently a hydrogen atom, D, F, Cl, Br, I, -N(R')₂, - CN, -NO₂, -OH, -COOR', -C(=O)R', -C(=O)NR', -P(=O)(R')₂, - S(=O)R', -S(=O)₂R', -OS(=O)₂R', a linear, branched or cyclic alkyl group having 1 to 6 carbon atoms, a linear or branched alkoxy group having 1 to 4 carbon atoms, a linear, branched or cyclic alkylthio group having 1 to 4 carbon atoms, a linear or branched alkenyl group having 2 to 4 carbon atoms, a linear or branched alkynyl group having 2 to 4 carbon atoms, an aromatic group having 5 to 60 carbon atoms, a heteroaromatic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms . These groups may be substituted with one or more R' other than a hydrogen atom.

Each R' is independently a hydrogen atom, D, F, -CN, a linear, branched or cyclic alkyl group having 1 to 6 carbon atoms, a linear or branched alkenyl group having 2 to 4 carbon atoms, or a linear or branched alkynyl group having 2 to 4 carbon atoms.]

### <Mechanism>

The iridium complex compound of the present invention has higher solubility in solvents, than conventional materials, and at the same time contributes to improving the luminous efficiency and operating lifetime of the device. The reason for this is assumed to be as follows.

In tris (2-phenylpyridine) iridium complex [Ir(ppy)₃], which is widely known as an iridium complex, the iridium atom has high electron donating properties. Therefore, the electron density at the para position to the iridium atom of the benzene ring covalently bonded to the iridium atom becomes high. This region is extremely susceptible to oxidation reactions and radical attacks, and due to the redox reaction that occurs within the light-emitting layer when driving a device using [Ir(ppy)₃] as a light-emitting material, [Ir(ppy)₃] quickly reacts with surrounding cation radical species and transforms into another substance. This causes the operating lifetime to be shortened.

Therefore, by substituting a phenyl group in advance at the para position of the benzene ring of [Ir(ppy)3], deterioration can be suppressed to some extent.

However, the electrons flowing from the iridium atom increase the electron density at the para position of the substituted phenyl group due to resonance, and this is not sufficient to suppress deterioration.

As in the present invention, when a para-biphenyl group (the partial structure is an iridium atom-para-terphenyl group) or a para-terphenyl group (the partial structure is an iridium atom-para-quaterphenyl group) is substituted to further extend the conjugated bond, the electrons flowing from the iridium atom are dispersed and accepted by three or more para-linked conjugated benzene rings. Therefore, a region with high electron density is not generated. That is, deterioration due to oxidation reactions can be sufficiently suppressed, and as a result, the operating lifetime of the element can be extended.

Further, factors that favorably influence the operating lifetime are explained below.

In the iridium complex compound of the present invention, the HOMO is widely distributed between the iridium atom and the above terphenylene site through π conjugation, making the iridium complex more susceptible to hole injection in the light-emitting layer. The oxidized iridium complex subsequently recombines with electrons to generate excitons. Since excitons are generated on the iridium complex, there is less opportunity for energy to be dissipated into other quenching processes than when the energy is transferred to the iridium complex after recombination on the host. Therefore, luminous efficiency can be increased.

When such iridium complexes having a structure that facilitates the transfer of holes can be present in the light-emitting layer at a high concentration, holes can be conducted more easily by hopping conduction between the iridium complexes. As a result, recombination on the iridium complex can occur in a wider area of the light-emitting layer.

One of the causes of reduced operating lifetime is that the recombination positions within the light-emitting layer are localized (for example, recombination occurs only near the interface between the light-emitting layer and the hole transport layer). Since the excited state of the iridium complex generated by recombination has a high energy state, there is a pathway that leads not only to light emission but also to decomposition of the complex. When the recombination position is localized, only the iridium complex present at that position is responsible for the light emission of the entire element. Therefore, it deteriorates in a short time and its operating lifetime is shortened. Conversely, by preventing localization of recombination sites and allowing recombination to occur widely within the light-emitting layer, the operating lifetime can be extended.

In order to allow the iridium complex to exist in the light-emitting layer at a high concentration (to the extent that concentration quenching does not occur), an ink (composition for forming a light-emitting layer) in which the iridium complex is dissolved at a high concentration is required. However, the para-terphenylene structure in the iridium complex of the present invention has poor solvent solubility because it has a linear structure unlike the metaterphenylene structure, which has a bent structure. For this reason, it is difficult to produce the above-mentioned highconcentration ink. When a flexible substituent such as an alkyl group or an aralkyl group is introduced to improve solvent solubility, the iridium complex is electrically insulated and shielded. As a result, the transfer of holes is significantly adversely affected, whereby the operating lifetime of the element is shortened.

However, when the meta(oligophenylene) skeleton represented by the above formula (2) is used, although the π-conjugated system is not extended, solvent solubility can be enhanced without undergoing insulating shielding due to the presence of π electrons that also exist in the oligophenylene skeleton. Here, when the number of benzene rings in the meta(oligophenylene) skeleton is small, the solubility is not sufficient. On the other hand, when it is too large, the molecular size becomes too large, which adversely affects the hopping movement of holes. However, within the scope of the present invention, both of these can be achieved.

In order to facilitate the transfer of holes between the iridium complexes in the light-emitting layer, it is preferable that all three bidentate ligands of the iridium complex are ligands as shown in formula (1) in the present invention. That is, L₃Ir (L represents a bidentate ligand) is preferred. This is because, in a complex containing at least one ligand with a different structure, that is, a L₂IrX type complex (X represents a bidentate ligand different from L), 1/3 of the space around the iridium complex is occupied by the X, so that there is a high possibility that the hole injection and transport properties are impaired.

### <n>

In formula (1), n is 1 or 2. From the viewpoint of operating lifetime, n=1 is preferable.

### <Substituent>

The substituents R and R¹ in the formula (1) and the formula (2) are each independent of each other and may be the same or different.

In the formula (1), there are a benzene ring directly bonded to Ir and n benzene rings. In this specification, the benzene ring directly bonded to Ir is referred to as a "benzene ring (Ir)", and the n benzene rings are referred to as a "benzene rings (n)", and these are collectively referred to as "benzene rings in the formula (1)".

### <Substituent R>

As described in the previous mechanism section, the substituent R is a substituent that exists in the terphenylene or quaterphenylene skeleton that exists at a site where the HOMO widely spreads. If a sterically bulky substituent exists here, the bond between phenylene rings or between phenyleneiridium atom will be greatly twisted and the conjugation of HOMO will be broken, which will greatly impair hole transport properties and reduce the effect of the present invention. Therefore, the substituent R is a hydrogen atom, D or F.

### <Substituent R¹>

The substituent R¹ is a substituent present at a substitution position that does not cause the above-mentioned HOMO twist, and is selected from the following substituent group W. However, in the case of a non-aromatic substituent, it has the effect of electrically insulating the iridium complex compound, so if it is too large, there is a risk of reducing the hole transporting property of the iridium complex compound. The number of carbon atoms is limited to such an extent that the effect does not appear.

### <Substituent Group W>

A hydrogen atom, D, F, Cl, Br, I, -N(R')₂, -CN, -NO₂, - OH, -COOR', -C(=O)R', -C(=O)NR', -P(=O)(R')₂, -S(=O)R', - S(=O)₂R', -OS(=O)₂R', a linear, branched or cyclic alkyl group having 1 to 6 carbon atoms, a linear or branched alkoxy group having 1 to 4 carbon atoms, a linear, branched or cyclic alkylthio group having 1 to 4 carbon atoms, a linear or branched alkenyl group having 2 to 4 carbon atoms, a linear or branched alkynyl group having 2 to 4 carbon atoms, an aromatic group having 5 to 60 carbon atoms, a heteroaromatic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms.

The alkyl group, the alkoxy group, the alkylthio group, the alkenyl group, the alkynyl group, the aromatic group, the heteroaromatic group, the diarylamino group, the arylheteroarylamino group, and the diheteroarylamino group may be further substituted with one or more R' other than a hydrogen atom.

R' will be described later.

Each substituent of the substituent group W will be described below.

Examples of the linear, branched or cyclic alkyl groups having 1 or more and 6 or less carbon atoms include methyl group, ethyl group, n-propyl group, isopropyl group, n-butyl group, n-pentyl group, n-hexyl group, isopropyl group, isobutyl group, cyclopentyl group, cyclohexyl group and the like. In the case of an alkyl group, the number of carbon atoms is preferably 1 or more, preferably 5 or less, and more preferably 4 or less, since a large number of carbon atoms will highly shield the iridium complex and impair durability.

Examples of the linear, branched or cyclic alkoxy groups having 1 or more and 4 or less carbon atoms include methoxy group, ethoxy group, n-propyloxy group, n-butoxy group and the like. From the viewpoint of durability, the number of carbon atoms is preferably 1 or more, preferably 3 or less, more preferably 2 or less, and most preferably 1.

Examples of the linear, branched or cyclic alkylthio groups having 1 or more and 4 or less carbon atoms include methylthio group, ethylthio group, n-propylthio group, n-butylthio group, and isopropylthio group. From the viewpoint of durability, the number of carbon atoms is preferably 1 or more, preferably 3 or less, more preferably 2 or less, and most preferably 1.

Examples of the linear or branched alkenyl groups having 2 or more and 4 or less carbon atoms include vinyl group, allyl group, propenyl group, butadiene group, and the like. From the viewpoint of durability, the number of carbon atoms is preferably 2 or more, preferably 3 or less, and most preferably 2.

Examples of the linear or branched alkynyl groups having 2 or more and 4 or less carbon atoms include ethynyl group, propionyl group, butynyl group and the like. From the viewpoint of durability, the number of carbon atoms is preferably 2 or more, preferably 3 or less, and most preferably 2.

The aromatic group having 5 or more and 60 or less carbon atoms and the heteroaromatic group having 5 or more carbon atoms and 60 or less carbon atoms may be present as a single ring or condensed ring. It may also be a group formed by bonding or condensing another type of aromatic group or heteroaromatic group to one ring.

Examples of these include phenyl group, naphthyl group, anthracenyl group, benzanthracenyl group, phenanthrenyl group, benzophenanthrenyl group, pyrenyl group, chrysenyl group, fluoranthenyl group, perylenyl group, benzopyrenyl group, benzofluoranthenyl group, naphthacenyl group, pentacenyl group, biphenyl group, terphenyl group, quaterphenyl group, quinquephenyl group, fluorenyl group, spirobifluorenyl group, dihydrophenanthrenyl group, dihydropyrenyl group, tetrahydropyrenyl group , indenofluorenyl group, furyl group, benzofuryl group, isobenzofuryl group, dibenzofuranyl group, thiophene group, benzothiophenyl group, dibenzothiophenyl group, pyrrolyl group, indolyl group, isoindolyl group, carbazolyl group, benzocarbazolyl group, indolocarbazolyl group, indenocarbazolyl group, pyridyl group, cinnolyl group, isocinnolyl group, acridyl group, phenanthridyl group, phenothiazinyl group, phenoxazyl group, pyrazolyl group, indazolyl group, imidazolyl group, benzimidazolyl group, naphthoimidazolyl group, phenanthroimidazolyl group, pyridineimidazolyl group, oxazolyl group, benzoxazolyl group, naphthoxazolyl group, thiazolyl group, benzothiazolyl group, pyrimidyl group, benzopyrimidyl group, pyridazinyl group, quinoxalinyl group , diazaanthracenyl group, diazapyrenyl group, pyrazinyl group, phenoxazinyl group, phenothiazinyl group, naphthyridinyl group, azacarbazolyl group, benzocarbolinyl group, phenanthrolinyl group, triazolyl group, benzotriazolyl group, oxadiazolyl group , thiadiazolyl group, triazinyl group, 2,6-diphenyl-1,3,5-triazin-4-yl group, tetrazolyl group, purinyl group, benzothiadiazolyl group, and the like.

From the viewpoint of balance between solubility and durability, phenyl group, naphthyl group, phenanthrenyl group, biphenyl group, terphenyl group, quaterphenyl group, quinquephenyl group, carbazolyl group, indolocarbazolyl group, indenocarbazolyl group, pyridyl group, pyrimidyl group, and triazinyl group are preferable, and phenyl group, biphenyl group, terphenyl group, quaterphenyl group, quinquephenyl group, and pyridyl group are more preferable, and phenyl group, biphenyl group, terphenyl group, and quaterphenyl group are most preferable.

From the viewpoint of balance between solubility and durability, the number of carbon atoms in these groups is preferably 5 or more, and preferably 50 or less, more preferably 40 or less, and most preferably 30 or less.

Examples of the diarylamino group having 10 or more and 40 or less carbon atoms include diphenylamino group, phenyl (naphthyl) amino group, di(biphenyl)amino group, di(p-terphenyl)amino group and the like. From the viewpoint of balance between solubility and durability, the number of carbon atoms in these diarylamino groups is preferably 10 or more, and preferably 36 or less, more preferably 30 or less, and most preferably 25 or less.

Examples of the arylheteroarylamino group having 10 or more and 40 or less carbon atoms include phenyl(2-pyridyl)amino group, phenyl(2,6-diphenyl-1,3,5-triazin-4-yl)amino group and the like. From the viewpoint of balance between solubility and durability, the number of carbon atoms in these arylheteroarylamino groups is preferably 10 or more, and preferably 36 or less, more preferably 30 or less, and most preferably 25 or less.

Examples of the diheteroarylamino group having 10 or more and 40 or less carbon atoms include di(2-pyridyl)amino group, di(2,6-diphenyl-1,3,5-triazin-4-yl)amino group and the like. From the viewpoint of balance between solubility and durability, the number of carbon atoms in these diheteroarylamino groups is preferably 10 or more, and preferably 36 or less, more and 30 or less, and most preferably 25 or less.

From the viewpoint of not impairing the durability as a light-emitting material in the organic electroluminescent element, substituents R¹ are preferably each independently a hydrogen atom, D, F, -CN, a linear, branched or cyclic alkyl group having 1 to 6 carbon atoms, an aromatic group having 5 to 60 carbon atoms, or a heteroaromatic group having 5 to 60 carbon atoms. The substituent R¹ is more preferably D, F, -CN, an aromatic group, or a heteroaromatic group.

The substituents R¹ is most preferably a hydrogen atom or D.

### <R'>

The above R' is each independently selected from the following substituent group W'.

### <Substituent group W'>

A hydrogen atom, D, F, -CN, linear, branched or cyclic alkyl group having 1 to 6 carbon atoms, linear or branched alkenyl group having 2 to 4 carbon atoms, linear or branched alkynyl group having 2 to 4 carbon atoms.

Examples of the above-mentioned linear, branched or cyclic alkyl group having 1 to 6 carbon atoms include linear or branched alkenyl group having 2 to 4 carbon atoms. Examples of the linear or branched alkynyl group having 2 to 4 carbon atoms include the linear, branched or cyclic alkyl groups, linear or branched alkenyl groups, and linear or branched alkynyl groups exemplified in the Substituent Group W.

### <Ar>

Ar in the above formula (1) is a structure represented by the above formula (2). The types of substituents R and R¹ on the benzene ring in formula (2) are the same as the types of the substituents R and R¹ in the formula (1).

The benzene rings in the formula (2) include the terminal benzene ring in the formula (2), m benzene rings, and the benzene ring bonded to the end of n benzene rings present in the formula (1).

In this specification, the terminal benzene ring in the formula (2) is referred to as "benzene ring (terminal)", m benzene rings are referred to as "benzene rings (m)", and the benzene ring bonded to the end of n benzene rings is referred to as "benzene ring (end)", and these are collectively referred to as "benzene rings in the formula (2)".

### <m>

In the formula (2), m is an integer from n+1 to n+5. From the viewpoint of durability, m is preferably n+1 to n+4, and more preferably n+1 to n+3.

### <Specific example>

Preferred specific examples of the iridium complex compound of the present invention are shown below. The iridium complex compound of the present invention is not limited to these.

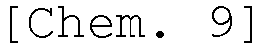

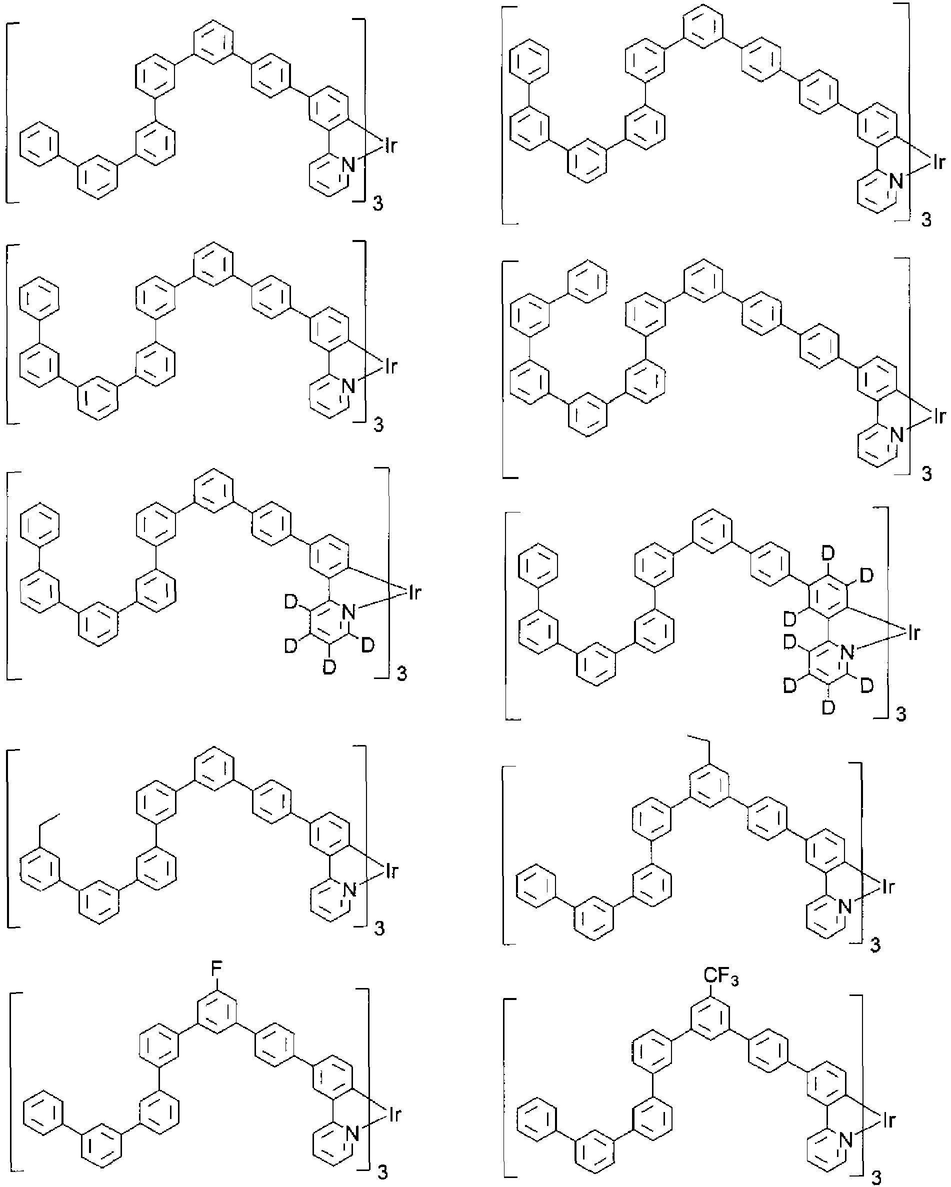

There is no particular limitation regarding the maximum emission wavelength of the iridium complex compound according to the present invention. The maximum emission wavelength of the iridium complex compound according to the present invention can be measured by, for example, a method described below.

### (Method for measuring maximum emission wavelength in solution)

At room temperature, the phosphorescence spectrum of a solution obtained by dissolving the iridium complex compound in toluene at a concentration of 1 × 10⁻⁴ mol/L or less is measured with a spectrophotometer (C9920-02 Organic EL quantum yield spectrometer manufactured by Hamamatsu Photonics K.K.). The wavelength at a maximum intensity in the measured phosphorescence spectrum is assumed to be a maximum emission wavelength in the present invention.

### <Method of synthesizing iridium complex compound>

The ligands of the iridium complex compound according to the present invention can be synthesized by using building blocks such as bromopyridine, 2-(3-bromophenyl) pyridine, and 1-bromo-3-iodopyridine, converting to a borate ester by Miyaura-Ishiyama boronation reaction or Hartwig-Miyaura C-H boronation rection, and constructing a skeleton by Suzuki-Miyaura coupling reaction between these intermediates and aryl halides. By combining other known methods, ligands into which various substituents have been introduced can be synthesized.

Examples of the method of synthesizing the iridium complex compound includes, but are not limited to, a method by which the target compound is obtained through a chloro-bridged iridium binuclear complex as expressed by reaction formula [A] below (M.G. Colombo, T.C. Brunold, T. Riedener, H.U. Gudel, Inorg. Chem., 1994, 33, 545-550), where a phenylpyridine ligand is used for ease of understanding, and a method by which the target compound is obtained after a binuclear complex is converted into a mononuclear complex by exchanging a chloro bridge for acetylacetonate ligand as expressed by reaction formula [B] below (S. Lamansky, P. Djurovich, D. Murphy, F. Abdel-Razzaq, R. Kwong, I. Tsyba, M. Borz, B. Mui, R. Bau, M. Thompson, Inorg. Chem., 2001, 40, 1704-1711). Furthermore, there is a method of reacting a ligand with a tris(acetylacetonato)iridium(III) complex in glycerin at high temperature to directly obtain a homotriscyclometallated iridium complex (K. Dedeian, P.I. Djurovich, F. O. Garces, G. Carlson, RJ Watts, Inorg. Chem., 1991, 30, 1685-1687). The method for synthesizing the iridium complex compound of the present invention is not limited to these.

The typical reaction conditions represented by the following formula [A] are as follows. In the first stage, a chloro-bridged iridium binuclear complex is synthesized through a reaction of 2 equivalents of a ligand and 1 equivalent of iridium chloride n-hydrate. Typically, a mixed solvent of 2-ethoxyethanol and water is used, but the reaction may be performed without a solvent or with another solvent. The reaction can be promoted by using the ligand in excess amount or using an additive such as a base. Instead of chlorine, other crosslinkable anionic ligands such as bromine can be used.

The reaction temperature is not particularly limited, and typically, it is preferably 0°C or more, more preferably 50°C or more, and preferably 250°C or less, more preferably 150°C or less. When the reaction temperature is in this range, the desired reaction alone tends to proceed with no by-products or decomposition reaction, thus achieving high selectivity.

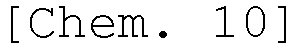

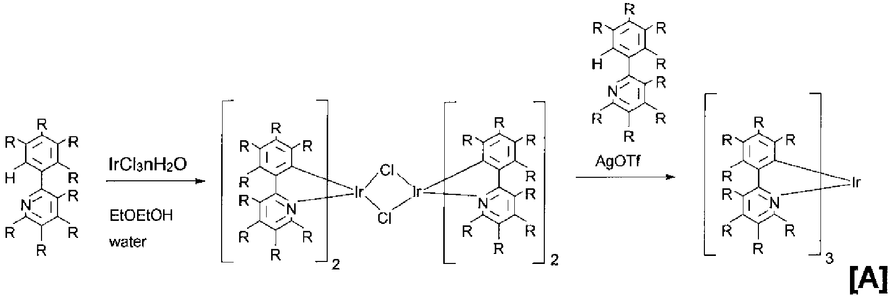

In the second stage, a halogen ion scavenger such as silver trifluoromethanesulfonate is added to bring the chloro-bridged iridium binuclear complex into contact with a newly added ligand, whereby the target complex is obtained. Typically, ethoxyethanol or diglyme is used as a solvent, but depending on the type of ligand, the reaction may be performed without a solvent, with another solvent, or with a mixture of two or more solvents. Although the halogen ion scavenger is not essential since the reaction may proceed without it, the addition of the scavenger is advantageous for increasing the reaction yield and selectively synthesizing a facial isomer having a higher quantum yield. The reaction temperature is typically, but not necessarily, in the range of 0°C to 250°C.

Typical reaction conditions expressed by reaction formula [B] below will be described. The binuclear complex in the first stage can be synthesized in the same manner as in reaction formula [A]. In the second stage, the binuclear complex is allowed to react with 1 equivalent or more of a 1,3-dione compound such as acetylacetone and 1 equivalent or more of a basic compound, such as sodium carbonate, that can abstract active hydrogen of the 1,3-dione compound, to thereby convert into a mononuclear complex coordinated with a 1,3-dionate ligand. Typically, a solvent such as ethoxyethanol or dichloromethane that can dissolve the starting binuclear complex is used, but when the ligand is liquid, the reaction can be performed without a solvent. The reaction temperature is typically, but not necessarily, in the range of 0°C to 200°C.

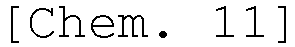

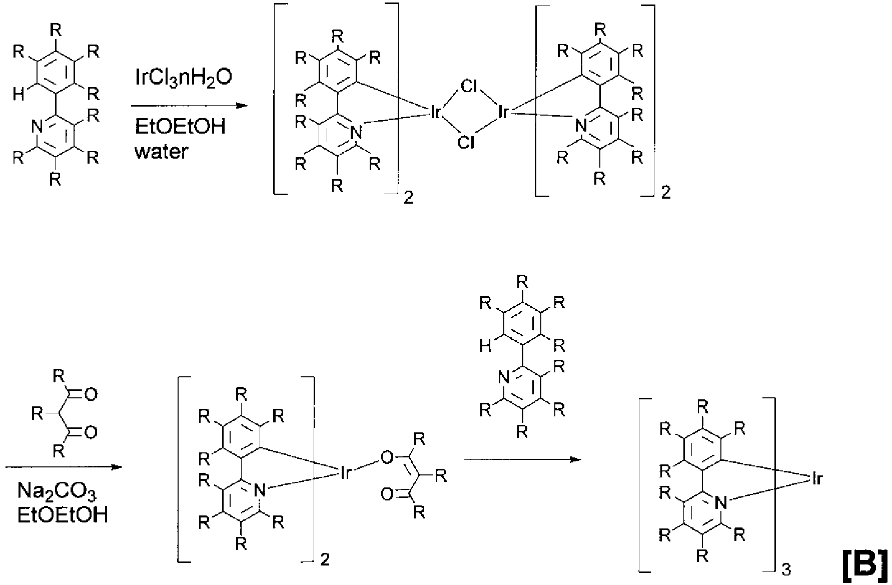

In the third stage, 1 equivalent or more of the ligand is allowed to react. The type and amount of solvent is not particularly limited, and when the ligand is liquid at a reaction temperature, the reaction may be performed without a solvent. The reaction temperature is also not particularly limited, but the reaction is often performed at a relatively high temperature of 100°C to 300°C because the reactivity is somewhat low. Thus, a high-boiling solvent such as glycerol is preferably used.

After the final reaction, purification is performed to remove unreacted raw materials, by-products, and the solvents. While a standard purification operation in synthetic organic chemistry can be used, purification by normal silica gel column chromatography is mainly performed as described in nonpatent literature above. As a developing solvent, hexane, heptane, dichloromethane, chloroform, ethyl acetate, toluene, methyl ethyl ketone, methanol, or a mixture thereof can be used. The purification may be performed more than once under different conditions. Purification operations such as other chromatography techniques (reverse phase silica gel chromatography, size exclusion chromatography, and paper chromatography), separate washing, reprecipitation, recrystallization, washing by powder suspension, and vacuum drying can be performed as required.

### <Applications for iridium complex compound>

The iridium complex compound of the present invention can be suitably used as a material used for an organic electroluminescent element, that is, a red light-emitting material for an organic electroluminescent element, and can also be suitably used as a light-emitting material for an organic electroluminescent element or an other light-emitting elements.

### [Iridium complex compound-containing composition]

The iridium complex compound of the present invention has high solvent solubility and thus is preferably used together with a solvent. A composition containing the iridium complex compound of the present invention and a solvent (hereinafter referred to as an "iridium complex compound-containing composition of the present invention" or simply referred to as an "iridium complex compound-containing composition") will be described below.

The iridium complex compound-containing composition of the present invention contains the above-described iridium complex compound of the present invention and a solvent. Furthermore, the iridium complex compound-containing composition of the present invention may contain one or more iridium complex compounds represented by formula (3) below. The iridium complex compound-containing composition of the present invention is typically used to form a layer or a film by a wet film-forming method, and in particular, the composition is preferably used to form an organic layer of an organic electroluminescent element. In particular, the organic layer is preferably a light-emitting layer. The iridium complex compound-containing composition is preferably a composition for an organic electroluminescent element, and is particularly preferably used as a composition for light-emitting layer formation.

The content of the iridium complex compound of the present invention in the iridium complex compound-containing composition is typically 0.001 mass% or more, preferably 0.01 mass% or more, and typically 99.9 mass% or less, preferably 99 mass% or less. When the content of the iridium complex compound in the composition is in this range, holes and electrons are efficiently injected from adjacent layers (e.g., a hole transport layer and a hole blocking layer) into a light-emitting layer, thus leading to a low drive voltage. The iridium complex compound of the present invention may be contained alone in the iridium complex compound-containing composition, or may be contained in combination of two or more.

When the iridium complex compound-containing composition of the present invention contains the iridium complex compound of the present invention represented by the above formula (1) and the iridium complex compound as another light-emitting material represented by the following formula (3), it is preferable that the total amount of these iridium complex compounds is contained so as to achieve the above iridium complex compound content.

In order to effectively obtain the below-mentioned effect of the present invention due to containing the iridium complex compound of the present invention represented by the above formula (1) and the below-mentioned effect of containing the iridium complex compound as another luminescent material represented by the following formula (3), the content of the iridium complex compound of the present invention represented by the formula (1) in the total 100% by mass of these iridium complex compounds should be 10% by mass or more, particularly 20% by mass or more. On the other hand, it is preferably 90% by mass or less.

The iridium complex compound-containing composition, when used, for example, for an organic electroluminescent element, may contain, in addition to the afore-mentioned iridium complex compound and the solvent, a charge transport compound used for an organic electroluminescent element, particularly, for a light-emitting layer.

The iridium complex compound-containing composition of the present invention, when used to form a light-emitting layer of an organic electroluminescent element, preferably contains the iridium complex compound of the present invention as a light-emitting material and another charge transport compound as a charge transport host material.

The solvent contained in the iridium complex compound-containing composition of the present invention is a volatile liquid component used to form a layer containing the iridium complex compound by wet film-formation.

Since the iridium complex compound of the present invention serving as a solute has high solvent solubility, the solvent is not particularly limited as long as it is an organic solvent in which the charge transport compounds described later are dissolved well.

Examples of preferred solvents include alkanes such as n-decane, cyclohexane, ethylcyclohexane, decalin, and bicyclohexane; aromatic hydrocarbons such as toluene, xylene, mesitylene, phenylcyclohexane, and tetralin; halogenated aromatic hydrocarbons such as chlorobenzene, dichlorobenzene, and trichlorobenzene; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic esters such as phenyl acetate, phenyl propionate, methyl benzoate, ethyl benzoate, propyl benzoate, and n-butyl benzoate; alicyclic ketones such as cyclohexanone, cyclooctanone, and fenchone; alicyclic alcohols such as cyclohexanol and cyclooctanol; aliphatic ketones such as methyl ethyl ketone and dibutyl ketone; aliphatic alcohols such as butanol and hexanol; and aliphatic ethers such as ethylene glycol dimethyl ether, ethylene glycol diethyl ether, and propylene glycol-1-monomethyl ether acetate (PGMEA).

Of these, alkanes and aromatic hydrocarbons are preferred. In particular, phenylcyclohexane has a viscosity and boiling point preferred for a wet film-forming process.

These solvents may be used alone, or two or more of them may be used in any combination and ratio.

The boiling point of the solvent used is typically 80°C or more, preferably 100°C or more, more preferably 120°C or more, and typically 270°C or less, preferably 250°C or less, more preferably 230°C or less. Below this range, the solvent may evaporate from the composition during wet film-formation, resulting in unstable film formation.

The content of the solvent in the iridium complex compound-containing composition is preferably 1 mass% or more, more preferably 10 mass% or more, particularly preferably 50 mass% or more, and preferably 99.99 mass% or less, more preferably 99.9 mass% or less, particularly preferably 99 mass% or less. The thickness of the light-emitting layer is typically about 3 to 200 nm, and when the content of the solvent is below this lower limit, the viscosity of the composition may be excessively high, resulting in low workability in film formation. When the content of the solvent is above this upper limit, the thickness of a film obtained by removing the solvent after film formation tends to be insufficient, thus resulting in unsuccessful film formation.

As the other charge transport compound that may be contained in the iridium complex compound-containing composition of the present invention, a compound conventionally used as a material for an organic electroluminescent element can be used. Examples include pyridine, carbazole, naphthalene, perylene, pyrene, anthracene, chrysene, naphthacene, phenanthrene, coronene, fluoranthene, benzophenanthrene, fluorene, acetonaphthofluoranthene, coumarin, p-bis(2-phenylethenyl)benzene, derivatives thereof, quinacridone derivatives, DCM (4-(dicyanomethylene)-2-methyl-6-(p-dimethylaminostyryl)-4H-pyran) compounds, benzopyran derivatives, rhodamine derivatives, benzothioxanthene derivatives, azabenzothioxanthene, arylamino-substituted fused aromatic ring compounds, and arylamino-substituted styryl derivatives.

These may be used alone, or two or more of them may be used in any combination and ratio.

Relative to 1 part by mass of the iridium complex compound of the present invention in the iridium complex compound-containing composition, the content of the other charge transport compound in the iridium complex compound-containing composition is typically 1,000 parts by mass or less, preferably 100 parts by mass or less, still more preferably 50 parts by mass or less, and typically 0.01 parts by mass or more, preferably 0.1 parts by mass or more, still more preferably 1 part by mass or more.

The iridium complex compound-containing composition of the present invention may optionally further contain other compounds in addition to the above-described compounds. For example, other solvents may be contained in addition to the above-described solvents. Examples of the other solvents include amides such as N,N-dimethylformamide and N,N-dimethylacetamide, and dimethylsulfoxide. These may be used alone, or two or more of them may be used in any combination and ratio.

### [Organic electroluminescent element]

An organic electroluminescent element using the iridium complex compound of the present invention (hereinafter sometimes referred to as "organic electroluminescent element of the present invention") will be described below.

An organic electroluminescent element of the present invention contains the iridium complex compound of the present invention.

The organic electroluminescent element of the present invention preferably includes a substrate, an anode and a cathode on the substrate, and one or more organic layers between the anode and the cathode, and at least one of the organic layers contains the iridium complex compound of the present invention. The organic layers include a light-emitting layer.

The organic layer containing the iridium complex compound of the present invention is more preferably a layer formed using the iridium complex compound-containing composition of the present invention, still more preferably a layer formed by a wet film-forming method. The layer formed by the wet film-forming method is preferably the light-emitting layer.

### (Wet film formation method)

The wet film forming method is a method in which a composition containing a solvent is applied onto a substrate, the solvent is then removed, and a film is formed. Examples of coating methods include wet film is forming methods such as a spin coating method, a dip coating method, a die coating method, a bar coating method, a blade coating method, a roll coating method, a spray coating method, a capillary coating method, an ink-jet method, a nozzle printing method, a screen printing method, a gravure printing method, or a flexographic printing method. The film formed by these methods is dried to form a film.

As a method for removing the solvent after coating, reduced pressure and/or heating can be used. The solvent removal method using reduced pressure is sometimes referred to as reduced pressure drying. Reduced pressure drying is a method in which a substrate coated with a composition is placed in a vacuum chamber and the solvent is removed by reducing the pressure. The method of removing the solvent by heating is sometimes referred to as heating drying. As the heating means used in heating drying, a clean oven or a hot plate is preferable because heating is applied evenly to the entire film.

The heating temperature in heating drying is arbitrary as long as it does not significantly impair the effects of the present invention. A higher heating temperature is preferable in terms of shortening the drying time, and a lower temperature is preferable in terms of less damage to the material. The upper limit of the heating temperature is usually 250°C or lower, preferably 200°C or lower, and more preferably 150°C or lower. The lower limit of the heating temperature is usually 30°C or higher, preferably 50°C or higher, and more preferably 80°C or higher.

Temperatures exceeding the above upper limit are undesirable because the heat resistance is higher than that of commonly used charge transport materials or phosphorescent materials, and there is a possibility of decomposition or crystallization. Temperatures below the above lower limit are not preferred because it takes a long time to remove the solvent. The heating time in the heating step is appropriately determined depending on the boiling point and vapor pressure of the solvent in the composition, the heat resistance of the material, and the heating conditions.

Either one or both of reduced pressure drying and heating drying may be performed. It is preferable to perform heat drying because the solvent can be easily removed. Further, it is preferable to reduce the amount of solvent contained in the coating film by drying under reduced pressure before heating and drying, since this can suppress the influence of retention and facilitate the formation of a flat and uniform film.

Fig. 1 is a schematic sectional view of an exemplary structure suitable for an organic electroluminescent element 10 of the present invention. In Fig. 1, reference numeral 1 denotes a substrate, reference numeral 2 an anode, reference numeral 3 a hole injection layer, reference numeral 4 a hole transport layer, reference numeral 5 a light-emitting layer, reference numeral 6 a hole blocking layer, reference numeral 7 an electron transport layer, reference numeral 8 an electron injection layer, and reference numeral 9 a cathode.

Materials used for the structure may be known materials and are not particularly limited. For each layer, an exemplary material and production method will be described below. It is intended that the content of any patent publications and journals cited herein may be appropriately applied or used within the common knowledge of a person skilled in the art.

### <Substrate 1>

The substrate 1 serves as a support for the organic electroluminescent element and is typically, for example, a quartz or glass plate, a metal plate or metal foil, or a plastic film or sheet. In particular, the substrate 1 is preferably a glass plate or a transparent synthetic resin plate made of, for example, polyester, polymethacrylate, polycarbonate, or polysulfone. The substrate 1 is preferably made of a material with high gas barrier properties to prevent deterioration of the organic electroluminescent element due to ambient air. In particular, when a material with low gas barrier properties, such as a synthetic resin substrate, is used, a dense silicon oxide film or the like is preferably disposed on at least one surface of the substrate 1 to improve the gas barrier properties.

### <Anode 2>

The anode 2 functions to inject holes into a layer on the light-emitting layer side. The anode 2 is typically made of a metal such as aluminum, gold, silver, nickel, palladium, or platinum; a metal oxide such as indium and/or tin oxide; a halogenated metal such as copper iodide; carbon black; a conductive polymer such as poly(3-methylthiophene), polypyrrole, or polyaniline; or the like.

The anode 2 is typically formed by a dry method such as a sputtering method or a vacuum deposition method. When the anode 2 is formed by using, for example, fine particles of a metal such as silver, fine particles of copper iodide or the like, carbon black, fine particles of a conductive metal oxide, or fine powder of a conductive polymer, a dispersion of such a material in an appropriate binder resin solution may be applied to the substrate to form the anode 2. In the case of a conductive polymer, the anode 2 can be formed by forming a thin film directly on a substrate through electrolytic polymerization or applying the conductive polymer on a substrate (Appl. Phys. Lett., vol. 60, p. 2711, 1992).

The anode 2 typically has a single-layer structure but may have a multilayer structure as appropriate. When the anode 2 has a multilayer structure, a different conductive material may be stacked on a first anode layer.

The thickness of the anode 2 may be determined according to, for example, the transparency required and the material used. When particularly high transparency is required, the thickness is preferably such that the visible light transmittance of the anode 2 is 60% or more, more preferably 80% or more. The thickness of the anode 2 is typically 5 nm or more, preferably 10 nm or more, and typically 1,000 nm or less, preferably 500 nm or less. When transparency is not required, the anode 2 may have any thickness according to, for example, the strength required. In this case, the anode 2 may have the same thickness as the substrate 1.

When a film is formed on a surface of the anode 2, it is preferable to perform, before the film formation, a treatment with ultraviolet rays + ozone, oxygen plasma, argon plasma, or the like to thereby remove impurities on the anode and adjust the ionization potential thereof to improve hole injection ability.

### <Hole injection layer 3>

The layer that functions to transport holes from the anode 2 side to the light-emitting layer 5 side is typically called a hole injection-transport layer or a hole transport layer. When there are two or more layers that function to transport holes from the anode 2 side to the light-emitting layer 5 side, the layer closer to the anode 2 side may be called a hole injection layer 3. The hole injection layer 3 is preferably used to enhance the function of transporting holes from the anode 2 to the light-emitting layer 5 side. When the hole injection layer 3 is used, the hole injection layer 3 is typically formed on the anode 2.

The thickness of the hole injection layer 3 is typically 1 nm or more, preferably 5 nm or more, and typically 1,000 nm or less, preferably 500 nm or less.

The hole injection layer 3 may be formed by a vacuum deposition method or a wet film-forming method. In terms of high film formability, the hole injection layer 3 is preferably formed by a wet film-forming method.

The hole injection layer 3 preferably contains a hole-transporting compound, more preferably contains a hole-transporting compound and an electron-accepting compound. Furthermore, the hole injection layer 3 preferably contains a cation radical compound, particularly preferably contains a cation radical compound and a hole-transporting compound.

### (Hole-transporting compound)

A composition for hole injection layer formation typically contains a hole-transporting compound that will form the hole injection layer 3.

In the case of a wet film-forming method, typically, a solvent is further contained. The composition for hole injection layer formation preferably has a high hole transport ability and can efficiently transport injected holes. Thus, the composition preferably has high hole mobility and is less likely to generate trapping impurities, for example, during production or use. In addition, the composition preferably has high stability, a low ionization potential, and high transparency to visible light. Particularly when the hole injection layer 3 is in contact with the light-emitting layer 5, the composition preferably does not quench light emitted from the light-emitting layer 5 and does not form an exciplex together with the light-emitting layer 5 to reduce light emission efficiency.

The hole-transporting compound is preferably a compound having an ionization potential of 4.5 eV to 6.0 eV from the viewpoint of a barrier to charge injection from the anode 2 to the hole injection layer 3. Examples of the hole-transporting compound include aromatic amine compounds, phthalocyanine compounds, porphyrin compounds, oligothiophene compounds, polythiophene compounds, benzylphenyl compounds, compounds having tertiary amines connected to each other through a fluorene group, hydrazone compounds, silazane compounds, and quinacridone compounds.

Among the above exemplary compounds, aromatic amine compounds are preferred, and aromatic tertiary amine compounds are particularly preferred, in terms of amorphous properties and visible light transmittance. Aromatic tertiary amine compounds are compounds having an aromatic tertiary amine structure and also include compounds having a group derived from an aromatic tertiary amine.

The type of aromatic tertiary amine compound is not particularly limited, but it is preferable to use a polymer compound having a weight average molecular weight of 1,000 or more and 1,000,000 or less (polymerized compound having a series of repeating units) because uniform light emission is readily provided due to the surface-smoothing effect. Examples of preferred aromatic tertiary amine polymer compounds include a polymer compound having a repeating unit represented by formula (I) below.

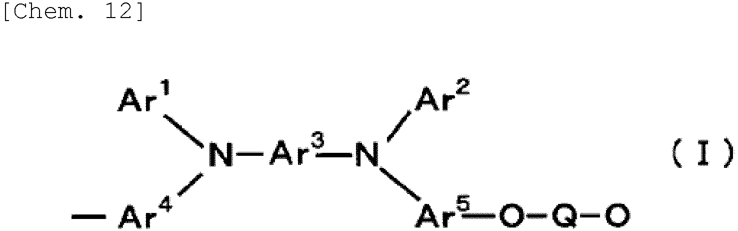

(In formula (I), Ar¹ and Ar² each independently represent an optionally substituted aromatic group or an optionally substituted heteroaromatic group. Ar³ to Ar⁵ each independently represent an optionally substituted aromatic group or an optionally substituted heteroaromatic group. Q represents a linking group selected from the group of linking groups given below. Among Ar¹ to Ar⁵, two groups bonded to the same N atom may be bonded together to form a ring.)

The linking groups are given below.

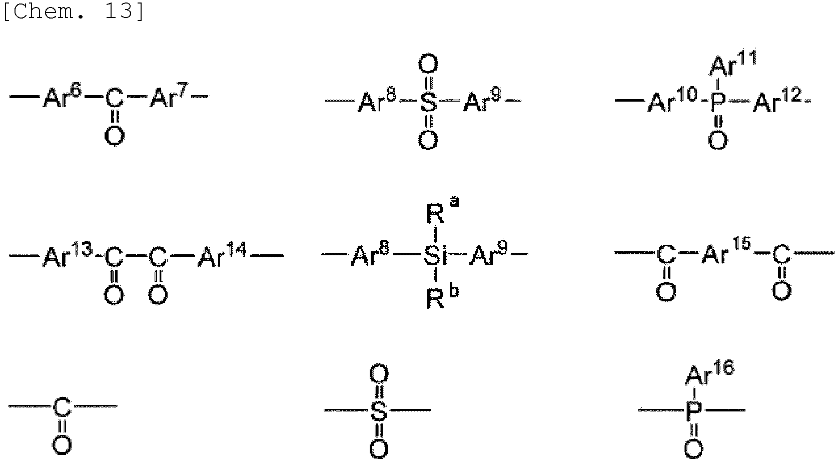

(In each of the above formulae, Ar⁶ to Ar¹⁶ each independently represent an optionally substituted aromatic group or an optionally substituted heteroaromatic group. R^{a} to R^{b} each independently represent a hydrogen atom or a substituent.)

In terms of solubility, heat resistance, and hole injection transport ability of the polymer compound, the aromatic groups and the heteroaromatic groups represented by Ar¹ to Ar¹⁶ are each preferably a group derived from a benzene ring, a naphthalene ring, a phenanthrene ring, a thiophene ring, or a pyridine ring, more preferably a group derived from a benzene ring or a naphthalene ring.

Specific examples of the aromatic tertiary amine polymer compound having the repeating unit represented by formula (I) include compounds described in International Publication No. 2005/089024.

### (Electron-accepting compound)

The hole injection layer 3 preferably contains an electron-accepting compound because the electric conductivity of the hole injection layer 3 can be improved through oxidation of the hole-transporting compound.

The electron-accepting compound is preferably a compound having oxidizing power and capable of accepting one electron from the above hole-transporting compound. Specifically, a compound having an electron affinity of 4 eV or more is preferred, and a compound having an electron affinity of 5 eV or more is more preferred.

Examples of such electron-accepting compounds include one or more compounds selected from the group consisting of triaryl boron compounds, halogenated metals, Lewis acids, organic acids, onium salts, salts of an arylamine and a halogenated metal, and salts of an arylamine and a Lewis acid. Specific examples include onium salts with a substituted organic group, such as 4-isopropyl-4'-methyldiphenyliodonium tetrakis(pentafluorophenyl)borate and triphenylsulfonium tetrafluoroborate (International Publication No. 2005/089024); high-valent inorganic compounds such as iron (III) chloride (Japanese Patent Publication No.H11-251067A) and ammonium peroxodisulfate; cyano compounds such as tetracyanoethylene; aromatic boron compounds such as tris(pentafluorophenyl)borane (Japanese Patent Publication No.2003-31365A); fullerene derivatives; and iodine.

### (Cation radical compound)

The cation radical compound is preferably an ionic compound composed of a cation radical, which is a chemical species resulting from the removal of one electron from a hole-transporting compound, and a counter anion. When the cation radical is derived from a hole-transporting polymer compound, the cation radical has a structure resulting from the removal of one electron from the repeating unit of the polymer compound.

The cation radical is preferably a chemical species that results from the removal of one electron from any of the compounds listed above as a hole-transporting compound. A chemical species that results from the removal of one electron from a compound preferred as a hole-transporting compound is suitable in terms of, for example, amorphous properties, visible light transmittance, heat resistance, and solubility.

The cation radical compound can be produced by mixing the hole-transporting compound and the electron-accepting compound. The mixing of the hole-transporting compound and the electron-accepting compound causes electrons to migrate from the hole-transporting compound to the electron-accepting compound, as a result of which a cationic compound composed of a cation radical of the hole-transporting compound and a counter anion is produced.

Polymer compound-derived cation radical compounds such as PEDOT/PSS (Adv. Mater., 2000, vol. 12, p. 481) and emeraldine hydrochloride (J. Phys. Chem., 1990, vol. 94, p. 7716) are produced also through oxidation polymerization (dehydrogenation polymerization).

As used herein, oxidation polymerization refers to oxidizing a monomer, in an acidic solution, chemically using peroxodisulfate or the like or electrochemically. In the case of oxidation polymerization (dehydrogenation polymerization), a monomer is oxidized to form a polymer, while one electron is removed from the repeating unit of the polymer to produce a cation radical with an anion derived from an acidic solution serving as a counter anion.

### (Formation of hole injection layer 3 by wet film-forming method)

When the hole injection layer 3 is formed by a wet film-forming method, it is typically formed by mixing a material that will form the hole injection layer 3 with an appropriate solvent (a solvent for a hole injection layer) to prepare a composition for film formation (composition for hole injection layer formation), applying the composition for hole injection layer formation onto a layer (typically, the anode 2) corresponding to an underlayer of the hole injection layer 3 by a wet film-forming method to form a film, and drying the film. The drying of the formed film can be performed in the same manner as the drying in the formation of the light-emitting layer 5 by a wet film-forming method.

The concentration of the hole-transporting compound in the composition for hole injection layer formation, although not particularly limited as long as the effects of the present invention are not greatly impaired, is preferably low in terms of thickness uniformity, and is preferably high in terms of defect resistance of the hole injection layer 3. The concentration is preferably 0.01 mass% or more, more preferably 0.1 mass% or more, particularly preferably 0.5 mass% or more, and preferably 70 mass% or less, more preferably 60 mass% or less, particularly preferably 50 mass% or less.

Examples of the solvent include ether solvents, ester solvents, aromatic hydrocarbon solvents, and amide solvents.

Examples of ether solvents include aliphatic ethers such as ethylene glycol dimethyl ether, ethylene glycol diethyl ether, and propylene glycol-1-monomethyl ether acetate (PGMEA) and aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole.

Examples of ester solvents include aromatic esters such as phenyl acetate, phenyl propionate, methyl benzoate, ethyl benzoate, propyl benzoate, and n-butyl benzoate.

Examples of aromatic hydrocarbon solvents include toluene, xylene, cyclohexylbenzene, 3-isopropylbiphenyl, 1,2,3,4-tetramethylbenzene, 1,4-diisopropylbenzene, and methylnaphthalene.

Examples of amide solvents include N,N-dimethylformamide and N,N-dimethylacetamide.

Other solvents such as dimethylsulfoxide can also be used.

The formation of the hole injection layer 3 by a wet film-forming method is typically performed by preparing the composition for hole injection layer formation, then applying the composition onto a layer (typically, the anode 2) corresponding to an underlayer of the hole injection layer 3 to form a film, and drying the film. In forming the hole injection layer 3, typically, the coating film is dried, for example, by heating or vacuum drying after the film formation.

### (Formation of hole injection layer 3 by vacuum deposition method)

When the hole injection layer 3 is formed by a vacuum deposition method, it is typically formed as described below. One or more of the constituent materials (e.g., the hole-transporting compound and the electron-accepting compound) of the hole injection layer 3 are placed in a crucible mounted in a vacuum chamber (when two or more materials are used, they are typically placed in different crucibles), and the vacuum chamber is evacuated with a vacuum pump to about 10⁻⁴ Pa. Thereafter, the crucible is heated (when two or more materials are used, the crucibles are typically each heated), and the material in the crucible is evaporated while controlling the amount of evaporation (when two or more materials are used, the materials are typically independently evaporated while controlling the amount of evaporation) to form the hole injection layer 3 on the anode 2 on a substrate placed so as to face the crucible. When two or more materials are used, a mixture thereof may be placed in a crucible, and heated and evaporated to form the hole injection layer 3.

The degree of vacuum during the deposition is not particularly limited as long as the effects of the present invention are not greatly impaired, and is typically 0.1 × 10⁻⁶ Torr (0.13 × 10⁻⁴ Pa) or more and 9.0 × 10⁻⁶ Torr (12.0 × 10⁻⁴ Pa) or less. The rate of deposition is not particularly limited as long as the effects of the present invention are not greatly impaired, and is typically 0.1 Å/s or more and 5.0 Å/s or less. The film formation temperature during the deposition is not particularly limited as long as the effects of the present invention are not greatly impaired, and is preferably 10°C or more and 50°C or less.

### <Hole transport layer 4>

A hole transport layer 4 is a layer that functions to transport holes from the anode 2 side to the light-emitting layer 5 side. Although the hole transport layer 4 is not essential in the organic electroluminescent element of the present invention, this layer is preferably provided in order to enhance the function of transporting holes from the anode 2 to the light-emitting layer 5. When the hole transport layer 4 is provided, the hole transport layer 4 is typically formed between the anode 2 and the light-emitting layer 5. When the hole injection layer 3 is present, the hole transport layer 4 is formed between the hole injection layer 3 and the light-emitting layer 5.

The thickness of the hole transport layer 4 is typically 5 nm or more, preferably 10 nm or more, and typically 300 nm or less, preferably 100 nm or less.

The hole transport layer 4 may be formed by a vacuum deposition method or a wet film-forming method. In terms of high film formability, the hole transport layer 4 is preferably formed by a wet film-forming method.

The hole transport layer 4 typically contains a hole-transporting compound. Specific examples of the hole-transporting compound contained in the hole transport layer 4 include aromatic diamines which contain two or more tertiary amines and in which two or more fused aromatic rings are substituted with nitrogen atoms, such as 4,4'-bis[N-(1-naphthyl)-N-phenylamino]biphenyl (Japanese Patent Publication No.H5-234681A); aromatic amine compounds having a starburst structure, such as 4,4',4"-tris(1-naphthylphenylamino)triphenylamine (J. Lumin., vols. 72-74, p. 985, 1997); aromatic amine compounds composed of a tetramer of triphenylamine (Chem. Commun., p. 2175, 1996); spiro compounds such as 2,2',7,7'-tetrakis-(diphenylamino)-9,9'-spirobifluorene (Synth. Metals, vol. 91, p. 209, 1997); and carbazole derivatives such as 4,4'-N,N'-dicarbazolebiphenyl. In addition, for example, polyvinylcarbazole, polyvinyltriphenylamine (Japanese Patent Publication No.H7-53953A), polyarylene ether sulfone containing tetraphenylbenzidine (Polym. Adv. Tech., vol. 7, p. 33, 1996), and the like can also be preferably used.

### (Formation of hole transport layer 4 by wet film-forming method)

When the hole transport layer 4 is formed by a wet film-forming method, it is typically formed as in the case where the hole injection layer 3 is formed by a wet film-forming method, except that the composition for hole injection layer formation is replaced with a composition for hole transport layer formation.

When the hole transport layer 4 is formed by a wet film-forming method, the composition for hole transport layer formation typically further contains a solvent. The solvent used for the composition for hole transport layer formation may be the same solvent as used for the composition for hole injection layer formation.

The concentration of the hole-transporting compound in the composition for hole transport layer formation may be in the same range as that of the concentration of the hole-transporting compound in the composition for hole injection layer formation.

The formation of the hole transport layer 4 by a wet film-forming method can be performed in the same manner as the formation of the hole injection layer 3.

### (Formation of hole transport layer 4 by vacuum deposition method)

Also when the hole transport layer 4 is formed by a vacuum deposition method, it can be typically formed as in the case where the hole injection layer 3 is formed by a vacuum deposition method, except that the constituent materials of the hole injection layer 3 are replaced with constituent materials of the hole transport layer 4. The film formation conditions, including the degree of vacuum during the deposition, the rate of deposition, and the temperature, may be the same as the conditions for the vacuum deposition of the hole injection layer 3.

### <Light-emitting layer 5>

The light-emitting layer 5 is a layer that functions to emit light upon being excited by recombination of holes injected from the anode 2 and electrons injected from a cathode 9 in response to an electric field applied between the pair of electrodes.

The light-emitting layer 5 is a layer formed between the anode 2 and the cathode 9. When the hole injection layer 3 is present on the anode 2, the light-emitting layer 5 is formed between the hole injection layer 3 and the cathode 9, and when the hole transport layer 4 is present on the anode 2, the light-emitting layer 5 is formed between the hole transport layer 4 and the cathode 9.

The thickness of the light-emitting layer 5, although not particularly limited as long as the effects of the present invention are not greatly impaired, is preferably large to prevent defects of the film, and is preferably small to help achieve a low drive voltage. For this reason, the thickness of the light-emitting layer 5 is preferably 3 nm or more, more preferably 5 nm or more, and preferably 200 nm or less, more preferably 100 nm or less.

The light-emitting layer 5 contains at least a material having light-emitting properties (light-emitting material), and preferably also contains a material having charge transport ability (charge-transporting material). It is only required that at least one of the light-emitting layers contain the iridium complex compound of the present invention as a light-emitting material, and other light-emitting materials may be used as appropriate. The light-emitting layer may contain two or more types of iridium complex compounds of the present invention. Light-emitting materials other than the iridium complex compound of the present invention will be described below in detail.

### (Light-emitting material)

The light-emitting material is not particularly limited as long as it emits light at a desired emission wavelength and the effects of the present invention are not impaired, and a known light-emitting material can be used. The light-emitting material may be a fluorescent material or a phosphorescent material, and is preferably a material with good light emission efficiency, preferably a phosphorescent material from the viewpoint of internal quantum efficiency.

Examples of the fluorescent material include the following materials.

Examples of fluorescent materials that provide blue-light emission (blue fluorescent materials) include naphthalene, perylene, pyrene, anthracene, coumarin, chrysene, p-bis(2-phenylethenyl)benzene, and derivatives thereof.

Examples of fluorescent materials that provide green-light emission (green fluorescent materials) include quinacridone derivatives, coumarin derivatives, and aluminum complexes such as Al(C₉H₆NO)₃.

Examples of fluorescent materials that provide yellow-light emission (yellow fluorescent materials) include rubrene and perimidone derivatives.

Examples of fluorescent materials that provide red-light emission (red fluorescent materials) include DCM (4-(dicyanomethylene)-2-methyl-6-(p-dimethylaminostyryl)-4H-pyran) compounds, benzopyran derivatives, rhodamine derivatives, benzothioxanthene derivatives, and azabenzothioxanthene.

Examples of the phosphorescent material include organometallic complexes containing a metal selected from groups 7 to 11 of the long-form periodic table (hereinafter, when the term "the periodic table" is used, it refers to the long-form periodic table, unless otherwise specified). Preferred examples of the metal selected from groups 7 to 11 of the periodic table include ruthenium, rhodium, palladium, silver, rhenium, osmium, iridium, platinum, and gold.

The ligand of such an organometallic complex is preferably a ligand in which a (hetero)aryl group is linked to pyridine, pyrazole, phenanthroline, or the like, such as a (hetero)arylpyridine ligand or a (hetero)arylpyrazole ligand, particularly preferably a phenylpyridine ligand or a phenylpyrazole ligand. Here, (hetero)aryl means an aryl group or a heteroaryl group.

Specific examples of preferred phosphorescent materials include phenylpyridine complexes such as tris(2-phenylpyridine)iridium, tris(2-phenylpyridine)ruthenium, tris(2-phenylpyridine)palladium, bis(2-phenylpyridine)platinum, tris(2-phenylpyridine)osmium, and tris(2-phenylpyridine)rhenium; and porphyrin complexes such as platinum octaethylporphyrin, platinum octaphenylporphyrin, palladium octaethylporphyrin, and palladium octaphenylporphyrin.

A particularly preferable material as another luminescent material is an iridium complex compound represented by the following formula (3). The iridium complex compound represented by the following formula (3) can reduce the influence on the emission wavelength and chromaticity of the organic EL element by appropriately selecting the substituents. At the same time, in the drying process of the composition for light-emitting layer formation (corresponding to the iridium complex compound-containing composition of the present invention) applied when forming the light-emitting layer, aggregation of the iridium complex compound can be suppressed, and deterioration in device performance can be prevented. Furthermore, it can be expected to improve the dissolution stability of the composition for light-emitting layer formation, that is, to prevent redeposition during long-term storage.

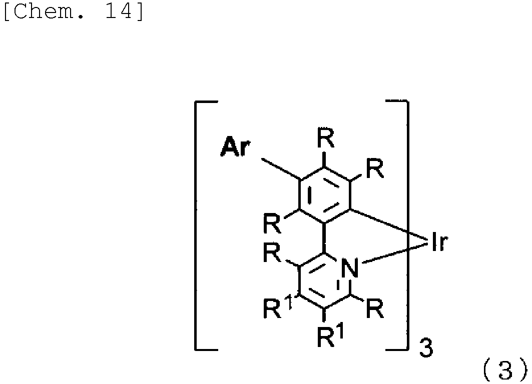

[In the formula (3), Ir represents an iridium atom. Ar is a structure represented by the above formula (2).]

The types and preferred ranges of substituents R and R¹ in formula (3) are the same as in formula (1) above. Moreover, Ar also has the same meaning as the above-mentioned formula (2). However, the range of m in this case is an integer from 1 to 6.

Specific examples of the iridium complex compounds represented by formula (3) that are particularly preferred as other luminescent materials are shown below.

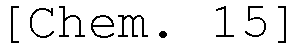

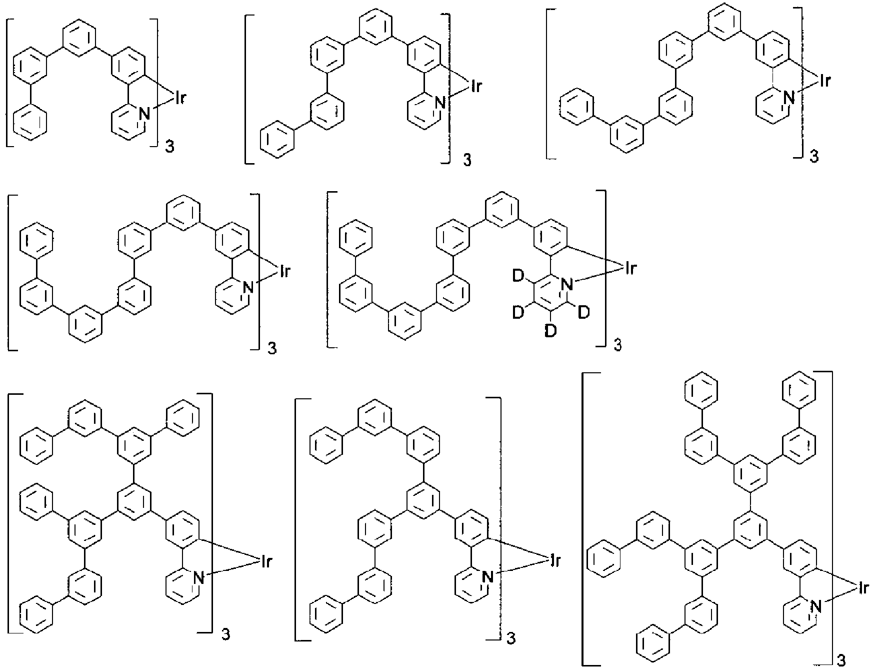

Examples of polymeric light-emitting materials include polyfluorene materials such as poly(9,9-dioctylfluorene-2,7-diyl), poly[(9,9-dioctylfluorene-2,7-diyl)-co-(4,4'-(N-(4-sec-butylphenyl))diphenylamine)], and poly[(9,9-dioctylfluorene-2,7-diyl)-co-(1,4-benzo-2{2,1'-3}-triazole)]; and polyphenylenevinylene materials such as poly[2-methoxy-5-(2-ethylhexyloxy)-1,4-phenylenevinylene].

### (Charge-transporting material)

The charge-transporting material is a material having a positive charge (hole) or negative charge (electron) transport ability and may be any known material as long as the effects of the present invention are not impaired.

The charge-transporting material may be, for example, a compound conventionally used for the light-emitting layer 5 of an organic electroluminescent element, and, in particular, is preferably a compound used as a host material of the light-emitting layer 5.

Specific examples of the charge-transporting material include the compounds exemplified as the hole-transporting compound of the hole injection layer 3, such as aromatic amine compounds, phthalocyanine compounds, porphyrin compounds, oligothiophene compounds, polythiophene compounds, benzylphenyl compounds, compounds having tertiary amines connected to each other through a fluorene group, hydrazone compounds, silazane compounds, silanamine compounds, phosphamine compounds, and quinacridone compounds; and electron-transporting compounds such as anthracene compounds, pyrene compounds, carbazole compounds, pyridine compounds, phenanthroline compounds, oxadiazole compounds, and silole compounds.

Also preferred for use as the charge-transporting material are, for example, the compounds exemplified as the hole-transporting compound of the hole transport layer 4, such as aromatic diamines which contain two or more tertiary amines and in which two or more fused aromatic rings are substituted with nitrogen atoms, as typified by 4,4'-bis[N-(1-naphthyl)-N-phenylamino]biphenyl (Japanese Patent Publication No.H5-234681A); aromatic amine compounds having a starburst structure, such as 4,4',4"-tris(1-naphthylphenylamino)triphenylamine (J. Lumin., vols. 72-74, p. 985, 1997); aromatic amine compounds composed of a tetramer of triphenylamine (Chem. Commun., p. 2175, 1996); fluoren compounds such as 2,2',7,7'-tetrakis-(diphenylamino)-9,9'-spirobifluorene (Synth. Metals, vol. 91, p. 209, 1997); and carbazole compounds such as 4,4'-N,N'-dicarbazolebiphenyl. Examples of the charge-transporting material also include oxadiazole compounds such as 2-(4-biphenylyl)-5-(p-tert-butylphenyl)-1,3,4-oxadiazole (tBu-PBD) and 2,5-bis(1-naphthyl)-1,3,4-oxadiazole (BND); silole compounds such as 2,5-bis(6'-(2',2"-bipyridyl))-1,1-dimethyl-3,4-diphenylsilole (PyPySPyPy); and phenanthroline compounds such as bathophenanthroline (BPhen) and 2,9-dimethyl-4,7-diphenyl-1,10-phenanthroline (BCP, bathocuproine).

### (Formation of light-emitting layer 5 by wet film-forming method)

The light-emitting layer 5 may be formed by a vacuum deposition method or a wet film-forming method. In terms of high film formability, the wet film-forming method is preferred.

When the light-emitting layer 5 is formed by a wet film-forming method, it is typically formed as in the case where the hole injection layer 3 is formed by a wet film-forming method, except that the composition for hole injection layer formation is replaced with a composition for light-emitting layer formation prepared by mixing a material that will form the light-emitting layer 5 with an appropriate solvent (a solvent for a light-emitting layer). In the present invention, the iridium complex compound-containing composition of the present invention is preferably used as the composition for light-emitting layer formation.

Examples of the solvent include the solvents exemplified for the formation of the hole injection layer 3, such as ether solvents, ester solvents, aromatic hydrocarbon solvents, and amide solvents; and alkane solvents, halogenated aromatic hydrocarbon solvents, aliphatic alcohol solvents, alicyclic alcohol solvents, aliphatic ketone solvents, and alicyclic ketone solvents. The solvent used is as exemplified also as the solvent of the iridium complex compound-containing composition of the present invention. Specific examples of the solvent are given below, but other solvents may also be used as long as the effects of the present invention are not impaired.

Examples include aliphatic ether solvents such as ethylene glycol dimethyl ether, ethylene glycol diethyl ether, and propylene glycol-1-monomethyl ether acetate (PGMEA); aromatic ether solvents such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic ester solvents such as phenyl acetate, phenyl propionate, methyl benzoate, ethyl benzoate, propyl benzoate, and n-butyl benzoate; aromatic hydrocarbon solvents such as toluene, xylene, mesitylene, cyclohexylbenzene, tetralin, 3-isopropylbiphenyl, 1,2,3,4-tetramethylbenzene, 1,4-diisopropylbenzene, and methylnaphthalene; amide solvents such as N,N-dimethylformamide and N,N-dimethylacetamide; alkane solvents such as n-decane, cyclohexane, ethylcyclohexane, decalin, and bicyclohexane; halogenated aromatic hydrocarbon solvents such as chlorobenzene, dichlorobenzene, and trichlorobenzene; aliphatic alcohol solvents such as butanol and hexanol; alicyclic alcohol solvents such as cyclohexanol and cyclooctanol; aliphatic ketone solvents such as methyl ethyl ketone and dibutyl ketone; and alicyclic ketone solvents such as cyclohexanone, cyclooctanone, and fenchone. Of these, alkane solvents and aromatic hydrocarbon solvents are particularly preferred.

To form a more uniform film, the solvent is preferably evaporated from a freshly formed liquid film at an appropriate rate. Thus, the boiling point of the solvent used, as described above, is typically 80°C or more, preferably 100°C or more, more preferably 120°C or more, and typically 270°C or less, preferably 250°C or less, more preferably 230°C or less.

The solvent may be used in any amount as long as the effects of the present invention are not greatly impaired, but the total content of the solvent in the composition for light-emitting layer formation, that is, the iridium complex compound-containing composition is preferably high in terms of ease of film-forming operation due to a low viscosity, and is preferably low in terms of ease of film formation due to a thick film. As described above, the content of the solvent in the iridium complex compound-containing composition is preferably 1 mass% or more, more preferably 10 mass% or more, particularly preferably 50 mass% or more, and preferably 99.99 mass% or less, more preferably 99.9 mass% or less, particularly preferably 99 mass% or less.

The solvent can be removed after the wet film formation, for example, by heating or pressure reduction. The heating means used for heating is preferably a clean oven or a hot plate because heat is uniformly applied to the whole film.

The heating temperature in the heating process, although not particularly limited as long as the effects of the present invention are not greatly impaired, is preferably high in terms of reduction in drying time, and is preferably low in terms of reduction in damage to the materials. The upper limit of the heating temperature is typically 250°C or less, preferably 200°C or less, more preferably 150°C or less. The lower limit of the heating temperature is typically 30°C or more, preferably 50°C or more, more preferably 80°C or more. Temperatures over the upper limit are higher than the level of heat resistance of a commonly used charge transport material or phosphorescent material and may disadvantageously cause decomposition or crystallization. When the heating temperature is below the lower limit, removal of the solvent disadvantageously requires a long time. The heating temperature in the heating process is appropriately determined according to the boiling point of the solvent in the composition for light-emitting layer formation, the vapor pressure, the heat resistance of the materials, and the heating conditions.

### (Formation of light-emitting layer 5 by vacuum deposition method)

When the light-emitting layer 5 is formed by a vacuum deposition method, it is typically formed as described below. One or more of the constituent materials (e.g., the light-emitting material and the charge transport compound) of the light-emitting layer 5 are placed in a crucible mounted in a vacuum chamber (when two or more materials are used, they are typically placed in different crucibles), and the vacuum chamber is evacuated with a vacuum pump to about 10⁻⁴ Pa. Thereafter, the crucible is heated (when two or more materials are used, the crucibles are typically each heated), and the material in the crucible is evaporated while controlling the amount of evaporation (when two or more materials are used, the materials are typically independently evaporated while controlling the amount of evaporation) to form the light-emitting layer 5 on the hole injection layer 3 or the hole transport layer 4 placed so as to face the crucible. When two or more materials are used, a mixture thereof may be placed in a crucible, and heated and evaporated to form the light-emitting layer 5.

The degree of vacuum during the deposition is not particularly limited as long as the effects of the present invention are not greatly impaired, and is typically 0.1 × 10⁻⁶ Torr (0.13 × 10⁻⁴ Pa) or more and 9.0 × 10⁻⁶ Torr (12.0 × 10⁻⁴ Pa) or less. The rate of deposition is not particularly limited as long as the effects of the present invention are not greatly impaired, and is typically 0.1 Å/s or more and 5.0 Å/s or less. The film formation temperature during the deposition is not particularly limited as long as the effects of the present invention are not greatly impaired, and is preferably 10°C or more and 50°C or less.

### <Hole blocking layer 6>

A hole blocking layer 6 may be disposed between the light-emitting layer 5 and an electron injection layer 8 described later. The hole blocking layer 6 is a layer stacked on the light-emitting layer 5 so as to be in contact with a surface of the light-emitting layer 5 on the cathode 9 side.

The hole blocking layer 6 serves to prevent holes moving from the anode 2 from reaching the cathode 9 and to efficiently transport electrons injected from the cathode 9 toward the light-emitting layer 5. The material forming the hole blocking layer 6 is required to have physical properties such as high electron mobility, low hole mobility, a large energy gap (difference between HOMO and LUMO), and a high excited triplet level (T1).

Examples of materials of the hole blocking layer 6 that satisfy such requirements include mixed ligand complexes such as bis(2-methyl-8-quinolinolate) (phenolate)aluminum and bis(2-methyl-8-quinolinolate) (triphenylsilanolate)aluminum; metal complexes such as a bis(2-methyl-8-quinolate)aluminum-µ-oxo-bis-(2-methyl-8-quinolinolate)aluminum dinuclear metal complex; styryl compounds such as distyrylbiphenyl derivatives (Japanese Patent Publication No. H11-242996A); triazole derivatives such as 3-(4-biphenylyl)-4-phenyl-5(4-tert-butylphenyl)-1,2,4-triazole (Japanese Patent Publication No.H7-41759A); and phenanthroline derivatives such as bathocuproine (Japanese Patent Publication No.H10-79297A). A compound having at least one pyridine ring substituted at the 2-, 4-, and 6- positions described in International Publication No. 2005/022962 is also preferred as the material of the hole blocking layer 6.

The hole blocking layer 6 may be formed by any method, and can be formed in the same manner as the light-emitting layer 5.

The thickness of the hole blocking layer 6, although not particularly limited as long as the effects of the present invention are not greatly impaired, is typically 0.3 nm or more, preferably 0.5 nm or more, and typically 100 nm or less, preferably 50 nm or less.

### <Electron transport layer 7>

An electron transport layer 7 is disposed between the light-emitting layer 5 or the hole blocking layer 6 and the electron injection layer 8 for the purpose of further improving the current efficiency of the element.

The electron transport layer 7 is formed of a compound that, between the electrodes under an electric field, is capable of efficiently transporting electrons injected from the cathode 9 toward the light-emitting layer 5. The electron-transporting compound used for the electron transport layer 7 needs to be a compound into which electrons from the cathode 9 or the electron injection layer 8 are injected with high efficiency and which has high electron mobility so that injected electrons can be efficiently transported.

Examples of electron-transporting compounds that satisfy such requirements include metal complexes such as aluminum complexes of 8-hydroxyquinoline (Japanese Patent Publication No.S59-194393A), metal complexes of 10-hydroxybenzo[h]quinoline, oxadiazole derivatives, distyrylbiphenyl derivatives, silole derivatives, 3-hydroxyflavone metal complexes, 5-hydroxyflavone metal complexes, benzoxazole metal complexes, benzothiazole metal complexes, trisbenzimidazolylbenzene (U.S. Patent No. 5645948), quinoxaline compounds (Japanese Patent Publication No.H6-207169A), phenanthroline derivatives (Japanese Patent Publication No.H5-331459A), 2-t-butyl-9,10-N,N'-dicyanoanthraquinonediimine, n-type hydrogenated amorphous silicon carbide, n-type zinc sulfide, and n-type zinc selenide.

The thickness of the electron transport layer 7 is typically 1 nm or more, preferably 5 nm or more, and typically 300 nm or less, preferably 100 nm or less.

The electron transport layer 7 is formed by being stacked on the light-emitting layer 5 or the hole blocking layer 6 by a wet film-forming method or a vacuum deposition method as with the light-emitting layer 5. Typically, a vacuum deposition method is used.

### <Electron injection layer 8>

The electron injection layer 8 serves to efficiently inject electrons injected from the cathode 9 into the electron transport layer 7 or the light-emitting layer 5.

To achieve efficient electron injection, the material forming the electron injection layer 8 is preferably a metal with a low work function. Examples include alkali metals such as sodium and cesium and alkaline-earth metals such as barium and calcium.

The thickness of the electron injection layer 8 is preferably 0.1 to 5 nm.

To interpose, as the electron injection layer 8, an ultrathin insulating film (about 0.1 to 5 nm thick) of LiF, MgF₂, Li₂O, Cs₂CO₃, or the like between the cathode 9 and the electron transport layer 7 is also an effective means for improving the efficiency of the element (Appl. Phys. Lett., vol. 70, p. 152, 1997; Japanese Patent Publication No.H10-74586A; IEEE Trans. Electron. Devices, vol. 44, p. 1245, 1997; and SID 04 Digest, p. 154).

Furthermore, to dope an organic electron transport material, as typified by nitrogen-containing heterocyclic compounds such as bathophenanthroline and metal complexes such as aluminum complexes of 8-hydroxyquinoline, with an alkali metal such as sodium, potassium, cesium, lithium, or rubidium (described in Japanese Patent Publication No.H10-270171A, Japanese Patent Publication No.2002-100478A, Japanese Patent Publication No.2002-100482A, etc.) is preferred because the electron injection/transport ability can be improved to achieve excellent film quality. In this case, the thickness of the film is typically 5 nm or more, preferably 10 nm or more, and typically 200 nm or less, preferably 100 nm or less.

The electron injection layer 8 is formed by being stacked on the light-emitting layer 5 or on the hole blocking layer 6 or the electron transport layer 7 thereon by a wet film-forming method or a vacuum deposition method as with the light-emitting layer 5.

Details in the case of a wet film-forming method are the same as in the case of the light-emitting layer 5.

### <Cathode 9>

The cathode 9 serves to inject electrons into a layer on the light-emitting layer 5 side (e.g., the electron injection layer 8 or the light-emitting layer 5). The material of the cathode 9 may be the same as the material used for the anode 2. For efficient electron injection, it is preferable to use a metal with a low work function, such as tin, magnesium, indium, calcium, aluminum, silver, or an alloy thereof. Examples of the material of the cathode 9 include alloy electrodes with a low work function, such as magnesium-silver alloys, magnesium-indium alloys, and aluminum-lithium alloys.

In terms of element stability, a metal layer having a high work function and stable to the atmosphere is preferably stacked on the cathode 9 to protect the cathode 9 formed of a metal with a low work function. Examples of the metal stacked include metals such as aluminum, silver, copper, nickel, chromium, gold, and platinum.

The thickness of the cathode is typically the same as that of the anode 2.

### <Other constituent layers>

While the description has been made mainly in the context of an element with a layer structure illustrated in Fig. 1, any desired layers, in addition to the layers described above, may be disposed between the anode 2 and the light-emitting layer 5 and between the cathode 9 and the light-emitting layer 5 in the organic electroluminescent element of the present invention, or any of the layers other than the light-emitting layer 5 may be omitted, as long as the performance of the element is not impaired.

For example, to dispose an electron blocking layer between the hole transport layer 4 and the light-emitting layer 5 is also effective for the same purpose as that of the hole blocking layer 6. The electron blocking layer serves to prevent electrons moving from the light-emitting layer 5 from reaching the hole transport layer 4, thereby increasing the probability of recombination of electrons with holes in the light-emitting layer 5 and confining the resultant excitons in the light-emitting layer 5, and also serves to efficiently transport holes injected from the hole transport layer 4 toward the light-emitting layer 5.

The electron blocking layer is required to have properties such as high hole transport ability, a large energy gap (difference between HOMO and LUMO), and a high excited triplet level (T1).

When the light-emitting layer 5 is formed by a wet film-forming method, the electron blocking layer is also preferably formed by a wet film-forming method for ease of element production.

Thus, the electron blocking layer also preferably has suitability for wet film formation, and examples of materials used for such electron blocking layers include copolymers of dioctylfluorene and triphenylamine, as typified by F8-TFB (International Publication No. 2004/084260).

The structure in Fig. 1 may be reversed; specifically, the cathode 9, the electron injection layer 8, the electron transport layer 7, the hole blocking layer 6, the light-emitting layer 5, the hole transport layer 4, the hole injection layer 3, and the anode 2 may be stacked in this order on the substrate 1. It is also possible to dispose the organic electroluminescent element of the present invention between two substrates at least one of which is highly transparent.

A structure formed of a plurality of the layer structures illustrated in Fig. 1 stacked on top of each other (a structure formed of a plurality of light-emitting units stacked on top of each other) is also possible. In this case, from the viewpoint of light emission efficiency and drive voltage, it is more preferable to use, for example, V₂O₅ as a charge generation layer in place of the interfacial layer (when the anode is ITO and the cathode is Al, the interfacial layer means these two layers) between the stages (between the light-emitting units) because such a configuration reduces the barrier between the stages.

The present invention can be applied to any of a single organic electroluminescent element, organic electroluminescent elements configured in an array arrangement, and a structure in which anodes and cathodes are arranged in an X-Y matrix.

### [Display device and illumination device]

### [Display device and lighting device]

A display device (hereinafter referred to as "display device of the present invention") and a illumination device (hereinafter referred to as " illumination device of the present invention") can be manufactured using the organic electroluminescent element of the present invention as described above.

The display device and the illumination device of the present invention may be of any type and may have any structure, and can be assembled according to an ordinary method by using the organic electroluminescent element of the present invention.

For example, the display device and the illumination device of the present invention can be formed by a method as described in "Organic EL Display" (Ohmsha, Ltd., published August 20, 2004, written by Shizuo Tokito, Chihaya Adachi, and Hideyuki Murata).

### EXAMPLES

The present invention will now be described in more detail with reference to examples. The present invention is not limited to the following examples, and any modifications can be made without departing from the scope of the present invention.

In the following synthesis examples, all reactions were performed under a stream of nitrogen. Solvents and solutions used for the reactions were used after being deaerated by appropriate methods such as nitrogen bubbling.

### [Synthesis of iridium complex compound]

### <Synthesis example 1: Synthesis of Compound (D-1)>

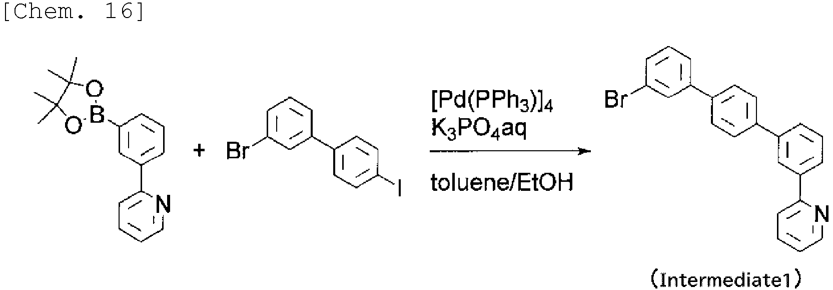

In a 300 mL recovery flask, 3-(2-pyridyl) phenylboronic acid pinacol ester (7.32 g), 3-bromo-4'-iodo-1,1'-biphenyl (9.45 g), tetrakis (triphenylphosphine) palladium (0) (0.62 g), 2M tripotassium phosphate aqueous solution (35 mL), toluene (50 mL) and ethanol (35 mL) were placed, and they were stirred under reflux for 8 hours. After cooling to room temperature, the aqueous phase was removed and the solvent was removed under reduced pressure. The resulting residue was purified by silica gel column chromatography (dichloromethane/hexane = 1/1 to 1/0), and 9.95 g of Intermediate 1 was obtained as a brown color amorphous material.

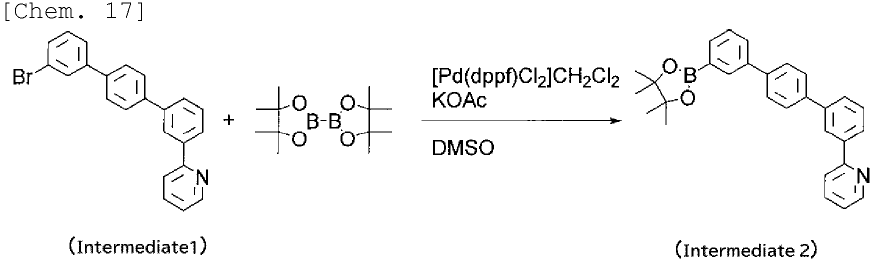

In a 1 L recovery flask, Intermediate 1 (28.7 g), bispinacolato diboron (23.7 g), potassium acetate (36.9 g), [Pd(dppf)₂Cl₂]CH₂Cl₂ (1.84 g) and dimethyl sulfoxide (250 mL) were placed, and they were stirred in a 90°C oil bath for 3 hours. After cooling to room temperature, water (0.5 L) and dichloromethane (0.3 L) were added for liquid separation washing, and after drying with magnesium sulfate, the solvent was removed under reduced pressure. The resulting residue was purified by silica gel column chromatography (ethyl acetate/hexane = 1/9 to 15/85) to obtain Intermediate 2 (30.1 g) as a pale yellow solid.

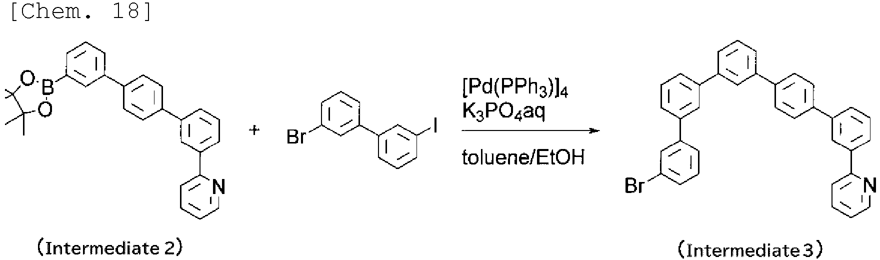

In a 1 L recovery flask, Intermediate 2 (30.1 g), 3-bromo-3'-iodo-1,1'-biphenyl (27.5g), tetrakis(triphenylphosphine) palladium (0) (1.06 g), 2M tripotassium phosphate aqueous solution (90 mL), toluene (300 mL) and ethanol (90 mL) were placed, and they were stirred under reflux for 4 hours. After cooling to room temperature, the aqueous phase was removed and the solvent was removed under reduced pressure. The resulting residue was purified by silica gel column chromatography (dichloromethane/hexane=1/1 to 7/3) to obtain 35.8 g of Intermediate 3 as a cream-colored amorphous.

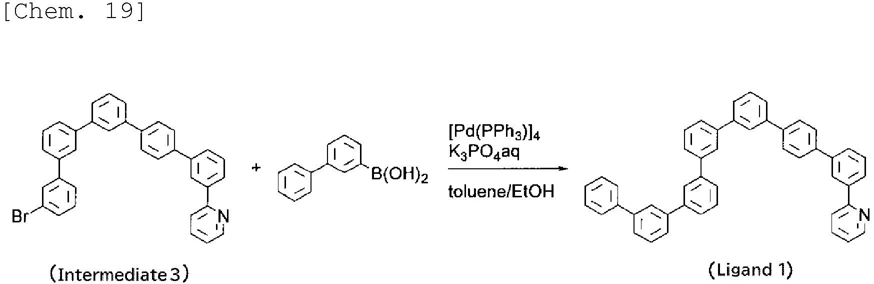

In a 300 mL recovery flask, Intermediate 3 (15.3 g), m-biphenylboronic acid (7.2g), tetrakis(triphenylphosphine) palladium (0) (1.25 g), 2M-tripotassium phosphate aqueous solution (45 mL), toluene (80 mL) and ethanol (45 mL) were placed, and they were stirred under reflux for 5 hours. After cooling to room temperature, the aqueous phase was removed and the solvent was removed under reduced pressure. The resulting residue was purified by silica gel column chromatography (dichloromethane/hexane = 1/1 to 1/0), and 18.2 g of Ligand 1 was obtained as white amorphous.

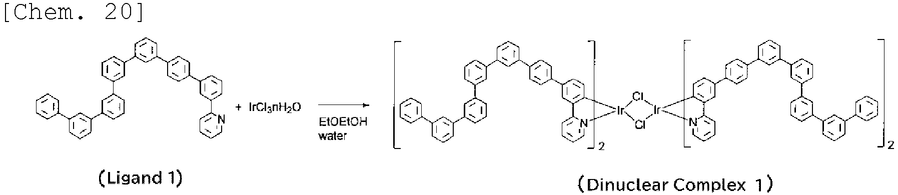

In a 200 mL three neck flask provided with Dimroth condenser with a side tube, Ligand 1 (10.2 g), iridium (III) chloride n-hydrate (manufactured by Furuya Metal Co., Ltd., 2.76 g), water (25 mL) and 2-ethoxyethanol (125 mL) were placed, and they were stirred in an oil bath at 140° C while distilling off the solvent. During the course of the reaction, after 2.5 hours, diglyme (40 mL) was added, and the oil bath was heated to 150°C. After an additional 2 hours, 2-ethoxyethanol (35 mL) was added and the oil bath was heated to 155°C. After an additional 4 hours, a solution of ethyldiisopropylamine (1.5 mL) in diglyme (2.5 mL) was added, and after a further 1 hour a solution of ethyldiisopropylamine (1.5 mL) in diglyme (2.5 mL) was added, followed by a further 2 hours stirring. The volume of liquid distilled off during the reaction was 140 mL. After cooling to room temperature, the residue obtained by removal under reduced pressure was purified by silica gel column chromatography (dichloromethane/hexane=4/6 to 3/7) to obtain 6.7 g of Dinuclear Complex 1 as bright yellow amorphous.

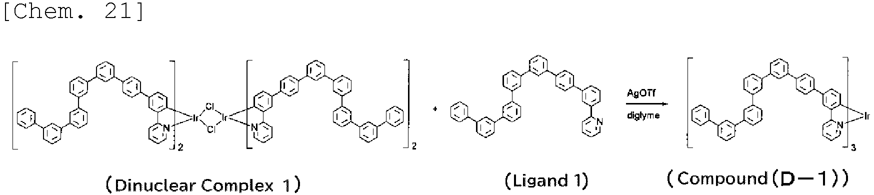

In a 200 mL recovery flask, Dinuclear Complex 1 (6.7 g), Ligand 1 (8.0 g), and diglyme (20 mL) were placed, and they were stirred in an oil bath at 135°C to dissolve, and then silver (I) trifluoromethanesulfonate (1.21 g) was added, the temperature of the oil bath was set to 140°C, and the mixture was stirred for 1.5 hours. The residue obtained by removing the solvent under reduced pressure was purified by silica gel column chromatography (dichloromethane/hexane=1/1) to obtain 7.7 g of Compound (D-1) as a yellow solid.

### <Synthesis Example 2: Synthesis of Compound (D-2)>

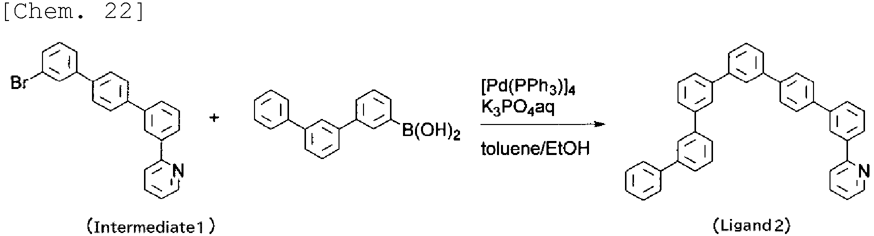

In a 1 L recovery flask, Intermediate 1 (10.0 g), [(1,1':3',1"-terphenyl)-3-yl]boronic acid (10.6g), tetrakis(triphenylphosphine) palladium (0) (0.68 g), 2M tripotassium phosphate aqueous solution (35 mL), toluene (65 mL) and ethanol (35 mL) were placed, and they were stirred under reflux for 5 hours. After cooling to room temperature, the aqueous phase was removed and the solvent was removed under reduced pressure. The resulting residue was purified by silica gel column chromatography (dichloromethane/hexane = 7/3 to 1/0), and 12.2 g of Ligand 2 was obtained as white amorphous.

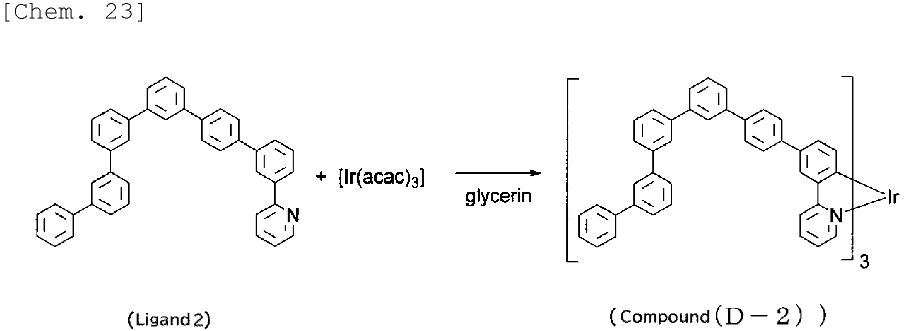

In a 100 mL recovery flask provided with Dimroth condenser with a side tube, Ligand 2 (12.2 g), tris(acetylacetonato)iridium (III) (2.6 g) and glycerin (15.4 g) were placed, and they were stirred in an oil bath at 240 °C for 7 hours. After cooling to room temperature, water (100 mL) and dichloromethane (100 mL) were added for liquid separation, and the oil phase was dried with magnesium sulfate. After filtration, the residue obtained by removing the solvent under reduced pressure was purified by silica gel column chromatography (dichloromethane/hexane=1/1) to obtain 2.75 g of Compound (D-2) as a yellow solid.

### <Synthesis Example 3: Synthesis of Compound (D-8)>

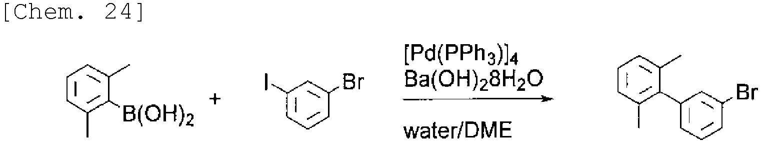

In a 1 L recovery flask, 2,6-dimethylphenylboronic acid (20.8 g), 1-bromo-3-iodobenzene (37.5 g), tetrakis (triphenylphosphine) palladium (0) (5.4 g), barium oxide octahydrate (62.9 g), water (150 mL) and 1,2-dimethoxyethane (400 mL) were placed, and they were stirred under reflux in an oil bath at 110°C for 3.5 hours. After cooling to room temperature, the aqueous phase was removed, and the residue obtained by removing the solvent under reduced pressure was purified by silica gel column chromatography (dichloromethane/hexane=1/200) to obtain 29.2 g of 3-bromo-2',6'-dimethylbiphenyl as a colorless oily substance.

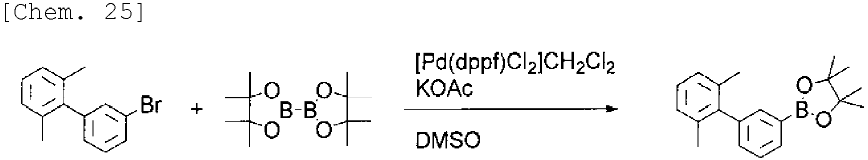

In a 1 L recovery flask, 3-bromo-2',6'-dimethylbiphenyl (29.1 g), bispinacolato diboron (34.8 g), potassium acetate (54.5 g), [Pd(dppf)₂Cl₂]CH₂Cl₂ (2 .9 g) and 1,4-dioxane (300 mL) were placed, and they were stirred in a oil bath at 90°C for 4.5 hours. After cooling to room temperature, the solvent was removed under reduced pressure. The resulting residue was purified by silica gel column chromatography (ethyl acetate/hexane = 1/9) to obtain 2-(2',6'-dimethyl[1,1'-biphenyl]-3-yl)-4,4,5,5-tetramethyl-1,3,2-dioxaborolane (31.1 g) as a white solid.

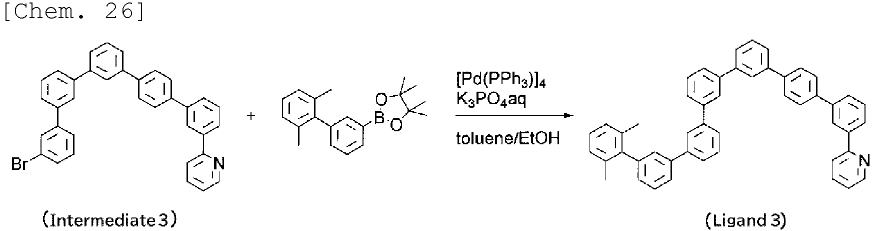

In a 100 mL recovery flask, Intermediate 3 (4.1 g), 2-(2',6'-dimethyl[1,1'-biphenyl]-3-yl)-4,4,5,5-tetramethyl-1,3,2-dioxaborolane (2.5 g), tetrakis(triphenylphosphine) palladium (0) (0.44 g), 2M-tripotassium phosphate aqueous solution (11 mL), toluene (24 mL) and ethanol (12 mL) were placed, and they were stirred under reflux in an oil bath at 95°C for 14 hours. After cooling to room temperature, the aqueous phase was removed and the solvent was removed under reduced pressure. The resulting residue was purified by silica gel column chromatography (ethyl acetate/hexane = 1/4 to 1/3) to obtain 4.3 g of Ligand 3 as a white amorphous.

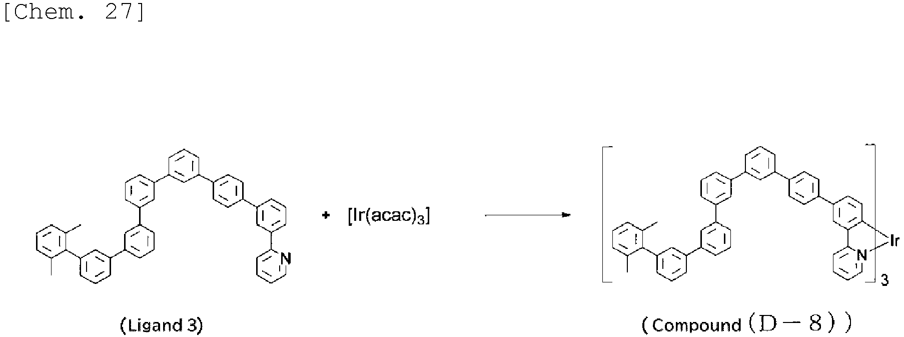

In a 100 mL recovery flask provided with Dimroth condenser with a side tube, Ligand 3 (3.9 g), tris (acetylacetonato) iridium(III) (0.75 g) and glycerin (4.6 g) were placed, and they were stirred in an oil bath at 240°C for 8 hours. After cooling to room temperature, water (30 mL) and dichloromethane (50 mL) were added for liquid separation, and the oil phase was dried with magnesium sulfate. After filtration, the residue obtained by removing the solvent under reduced pressure was purified by silica gel column chromatography (dichloromethane/hexane=1/1) to obtain 0.75 g of Compound (D-8) as a yellow solid.

### <Synthesis Example 4: Synthesis of Compound (D-9)>

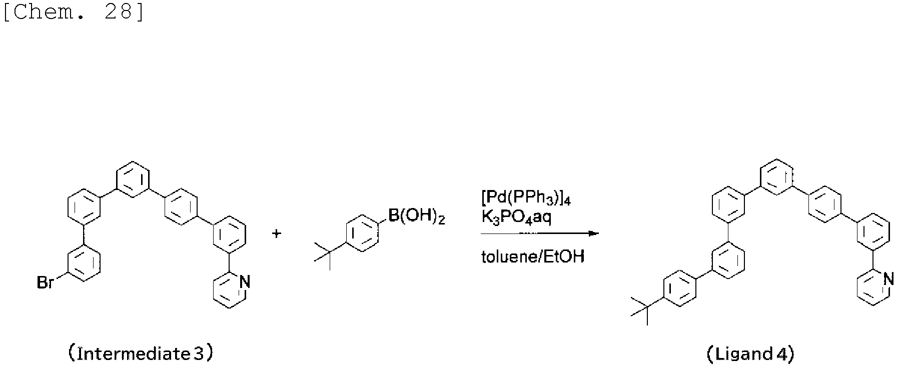

In a 100 mL recovery flask, Intermediate 3 (4.8 g), 4-tert-butylphenylboronic acid (1.7 g), tetrakis(triphenylphosphine) palladium (0) (0.51 g), 2M-tripotassium phosphate aqueous solution (13 mL), toluene (28 mL) and ethanol (14 mL) were placed, and they were stirred under reflux in an oil bath at 95°C for 8.5 hours. After cooling to room temperature, the aqueous phase was removed, and the residue obtained by removing the solvent under reduced pressure was purified by silica gel column chromatography (ethyl acetate/hexane = 1/4) to obtain 3.8 g of Ligand 4 as a white amorphous.

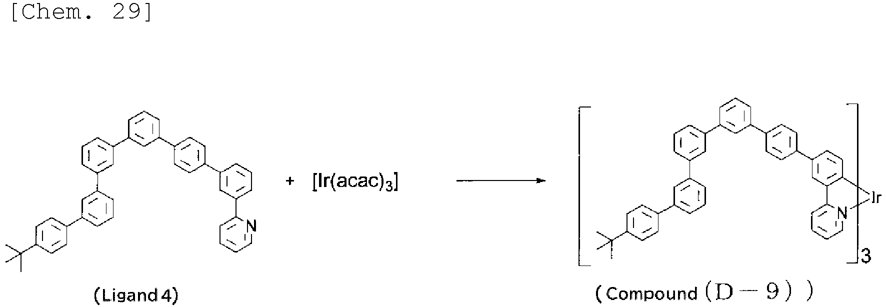

In a 100 mL recovery flask provided with Dimroth condenser with a side tube, Ligand 4 (3.8 g), tris (acetylacetonato) iridium(III) (0.78 g) and glycerin (4.5 g) were placed, and they were stirred in an oil bath at 240°C for 9 hours. After cooling to room temperature, water (30 mL) and dichloromethane (50 mL) were added to liquid separation, and the oil phase was dried with magnesium sulfate. After filtration, the solvent was removed under reduced pressure and the resulting residue was purified by silica gel column chromatography (dichloromethane/hexane = 1/1) to obtain 1.11 g of Compound (D-9) as a yellow solid.

### [Manufacture and performance evaluation of organic electroluminescent elements]

### [Example 1]

An organic electroluminescent element was manufactured by a method described below.

A positive electrode was formed by patterning a deposit of indium-tin oxide (ITO) transparent conductive film having a thickness of 50 nm on a glass substrate (manufactured by Geomatec, sputtered film) into a stripe having a width of 2 mm by ordinary photolithographic technology and hydrochloric acid etching. The substrate provided with the patterned ITO was subjected to washing in the order of ultrasonic cleaning with a surfactant aqueous solution, water washing with ultrapure water, ultrasonic cleaning with ultrapure water, and water washing with ultrapure water and, thereafter, was dried with dry air. Finally, ultraviolet ozone cleaning was performed.

As a hole-injection-layer-forming composition, a composition in which 3.0% by mass of hole-transporting polymer compound having a repeating structure denoted by the formula (P-1) below and 0.6% by mass of electron-accepting compound (HI-1) were dissolved in ethyl benzoate was prepared.

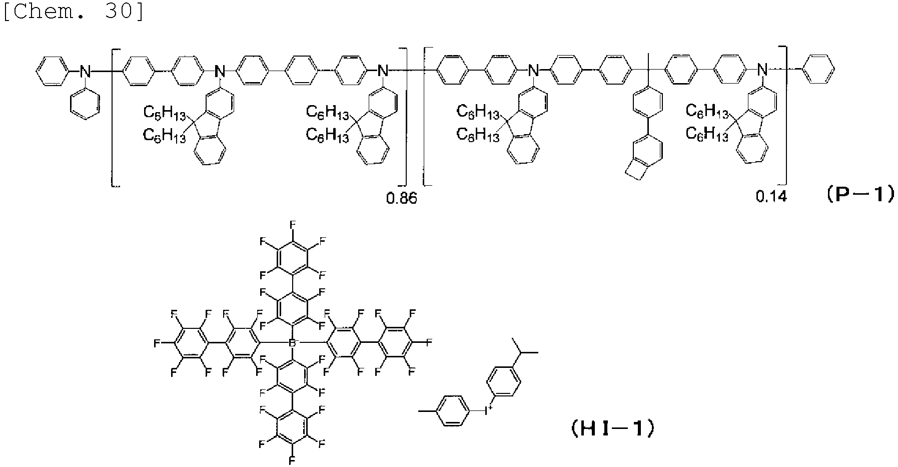

The substrate was spin-coated with the hole-injection-layer-forming composition in air, drying was performed by a hot plate at 240°C for 30 minutes in air so as to form a uniform thin film having a film thickness of 40 nm and serving as a hole injection layer.

Next, a hole-transporting-layer-forming composition was prepared by dissolving a charge-transporting polymer compound denoted by the structural formula (HT-1) below in 1,3,5-trimethylbenzene at a concentration of 2.0% by mass.

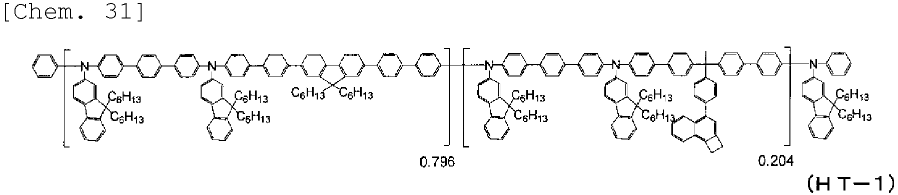

The substrate provided with the hole injection layer through the coating film formation was spin-coated with the hole-transporting-layer-forming composition in a nitrogen glove box, and drying was performed by a hot plate in the nitrogen glove box at 230°C for 30 minutes so as to form a uniform thin film having a film thickness of 40 nm and serving as a hole-transporting layer.

Subsequently, 1.3% by mass of a Compound (H-1), 1.3% by mass of Compound (H-2), 2.6% by mass of Compound (H-3), and Compound (D-1) of the present invention, having the following structure, was dissolved in cyclohexylbenzene at a concentration of 1.56% by mass to prepare a material for a light-emitting-layer-forming composition.

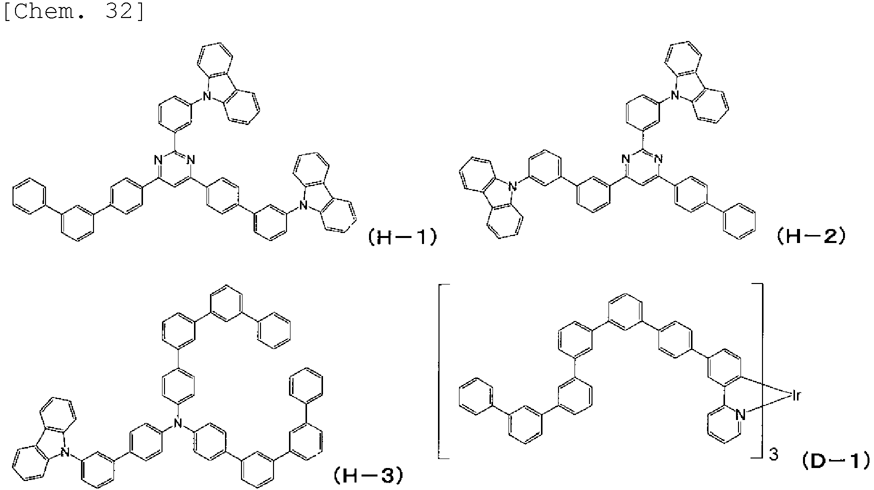

The substrate provided with the hole-transporting layer through coating film formation was spin-coated with the light-emitting-layer-forming composition in a nitrogen glove box, and drying was performed by using a hot plate in the nitrogen glove box at 120°C for 20 minutes so as to form a uniform thin film having a film thickness of 40 nm and serving as a light-emitting layer.

The substrate on which films up to the light-emitting layer were formed was placed in a vacuum deposition apparatus, and the interior of the apparatus was evacuated to 2 × 10⁻⁴ Pa or less.

Next, a compound having the structural formula (ET-1) below and 8-hydroxyquinolinolato-lithium were co-deposited on the light-emitting layer at a film thickness ratio of 2:3 by a vacuum deposition method so as to form an electron transport layer having a film thickness of 30 nm.

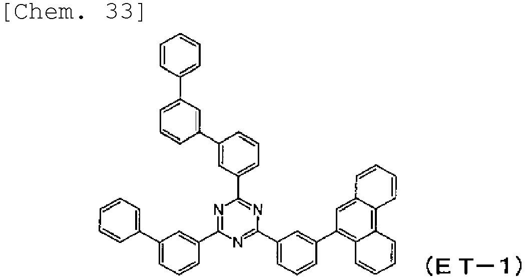

Subsequently, a 2-mm-width-stripe-like shadow mask for negative electrode deposition was made to adhere to the substrate so as to orthogonal to the ITO stripe of the positive electrode. Then, aluminum was heated by a molybdenum boat, and an aluminum layer having a film thickness of 80 nm was formed so as to form a negative electrode.

In this manner, an organic electroluminescent element including a light emission area portion with a size of 2 mm × 2 mm was obtained.

### [Example 2]

An organic electroluminescent element was produced in the same manner as in Example 1, except that Compound (D-2) having the following structure was used instead of Compound (D-1) to prepare a light-emitting-layer-forming composition.

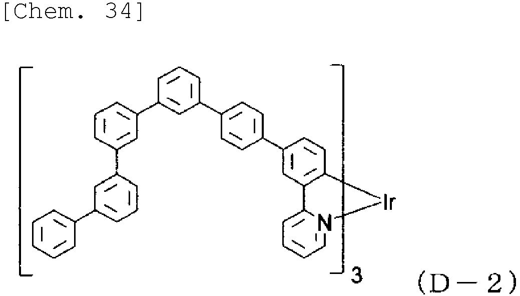

### [Comparative Example 1]

An organic electroluminescent element was produced in the same manner as in Example 1, except that Compound (D-3) having the following structure was used instead of Compound (D-1) to prepare a light-emitting-layer-forming composition.

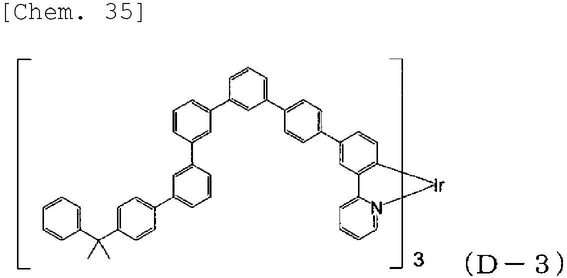

### [Comparative Example 2]

An organic electroluminescent element was produced in the same manner as in Example 1, except that Compound (D-4) having the following structure was used instead of Compound (D-1) to prepare a light-emitting-layer-forming composition.

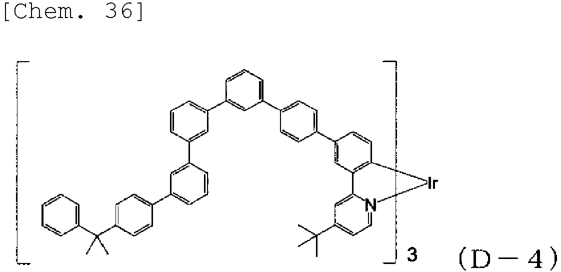

### [Example 3]

An organic electroluminescent element was produced in the same manner as in Example 1, except that 0.39% by mass of the Compound (D-6) and 1.17% by mass of the Compound (D-1) were used instead of Compound (D-1) to prepare a light-emitting-layer-forming composition. Compound (D-6) was synthesized with reference to the method described in Japanese Patent Publication No.2014-074000 A.

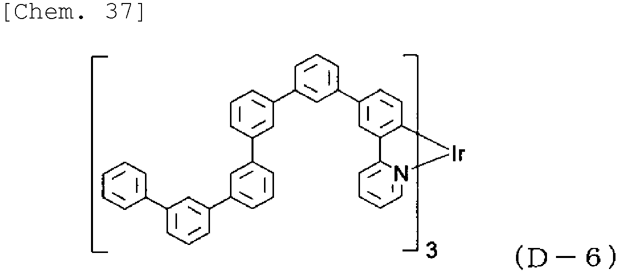

### [Example 4]

An organic electroluminescent element was produced in the same manner as in Example 1, except that 0.78% by mass of Compound (D-6) and 0.78% by mass of Compound (D-1) ware used instead of Compound (D-1) to prepare a light-emitting-layer-forming composition.

### [Comparative Example 3]

An organic electroluminescent element was produced in the same manner as in Example 1, except that Compound (D-5) having the following structure was used instead of Compound (D-1) to prepare a light-emitting-layer-forming composition. Compound (D-5) was synthesized with reference to the method for synthesizing Compound (D-1).

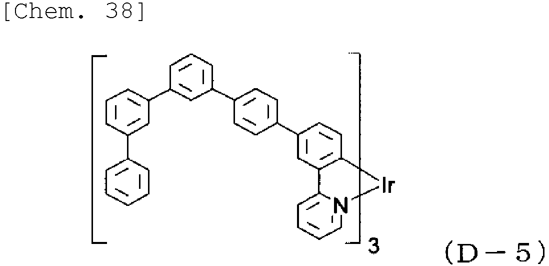

### [Comparative Example 4]

An organic electroluminescent element was produced in the same manner as in Example 1, except that Compound (D-6) was used instead of Compound (D-1) to prepare a light-emitting-layer-forming composition.

### [Comparative Example 5]

An organic electroluminescent element was produced in the same manner as in Example 1, except that Compound (D-7) having the following structure was used instead of Compound (D-1) to prepare a light-emitting-layer-forming composition. Compound (D-7) was synthesized by the method described in Japanese Patent Publication No.2014-074000A.

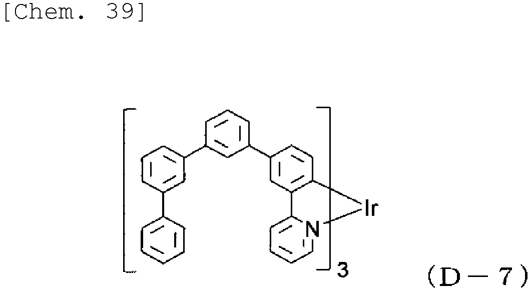

### [Example 5]

An organic electroluminescent element was produced in the same manner as in Example 1, except that Compound (D-8) was used instead of Compound (D-1) to prepare a light-emitting-layer-forming composition.

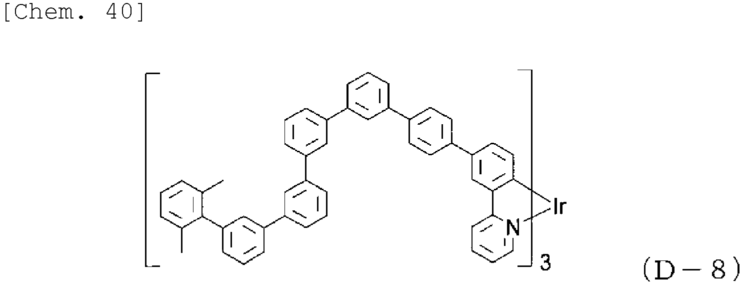

### [Example 6]

An organic electroluminescent element was produced in the same manner as in Example 1, except that Compound (D-9) was used instead of Compound (D-1) to prepare a light-emitting-layer-forming composition.

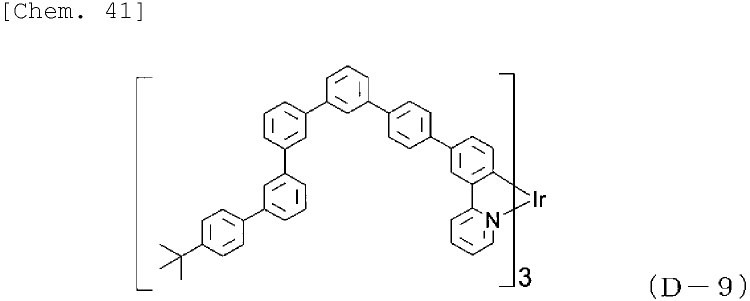

### [Comparative Example 6]

An organic electroluminescent element was produced in the same manner as in Example 1, except that Compound (D-10) having the following structure was used instead of Compound (D-1) to prepare a light-emitting-layer-forming composition. Compound (D-10) was synthesized by the method described in Japanese Patent Publication No.2021-138735A.

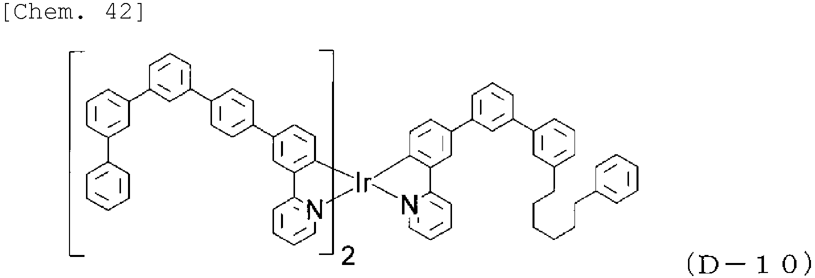

### [Evaluation of Element]

The voltage (V) and external quantum efficiency (%) were measured when the organic electroluminescent elements obtained in Examples 1 to 6 and Comparative Examples 1 to 6 emitted light at 1,000 cd/m². Further, when the device was continuously energized at a current density of 15 mA/cm² , the time (LT90) for the brightness to decrease to 90% of the initial brightness was measured.

The value obtained by subtracting the voltage of Comparative Example 1 from the voltage of Example 1 was defined as the relative voltage (V) of Example 1. A value obtained by dividing the external quantum efficiency of Example 1 by the external quantum efficiency of Comparative Example 1 was defined as the relative external quantum efficiency of Example 1. A value obtained by dividing LT90 of Example 1 by LT90 of Comparative Example 1 was defined as the relative drive life of Example 1.

Similarly, the value obtained by subtracting the voltage of Comparative Example 1 from the voltage of Example 2 was defined as the relative voltage (V) of Example 2. A value obtained by dividing the external quantum efficiency of Example 2 by the external quantum efficiency of Comparative Example 1 was defined as the relative external quantum efficiency of Example 2. The value obtained by dividing the LT90 of Example 2 by the LT90 of Comparative Example 1 was defined as the relative drive life of Example 2.

Similarly, the value obtained by subtracting the voltage of Comparative Example 1 from the voltage of Comparative Example 2 was defined as the relative voltage (V) of Comparative Example 2. A value obtained by dividing the external quantum efficiency of Comparative Example 2 by the external quantum efficiency of Comparative Example 1 was defined as the relative external quantum efficiency of Comparative Example 2. The value obtained by dividing the LT90 of Comparative Example 2 by the LT90 of Comparative Example 1 was defined as the relative drive life of Comparative Example 2.

The same applies to Examples 3 to 6 and Comparative Examples 3 to 6 below.

The results of these measurements are shown in Table 1.

**[Table 1]**

| | Light-Emitting Material | Relative Voltage Difference (V) | Relative External Quantum Efficiency | Relative Drive Life |
|---|---|---|---|---|
| Example 1 | D-1 | -0.13 | 1.05 | 1.30 |
| Example 2 | D-2 | -0.23 | 1.03 | 1.40 |
| Comparative Example 1 | D-3 | ±O | 1 | 1 |
| Comparative Example 2 | D-4 | 0.35 | 1.02 | 0.75 |
| Example3 | D-1 : D-6 (3:1) | -0.10 | 1.05 | 1.34 |
| Example4 | D-1:D-6 (1:1) | -0.03 | 1.04 | 1.22 |
| Comparative Example3 | D-5 | -0.30 | 0.88 | 0.07 |
| Comparative Example4 | D-6 | -0.05 | 1.00 | 1.12 |
| Comparative Example5 | D-7 | -0.18 | 0.96 | 0.33 |
| Example 5 | D-8 | -0.09 | 1.09 | 1.10 |
| Example6 | D-9 | -0.09 | 1.06 | 1.27 |
| Comparative Example6 | D-10 | -0.25 | 0.99 | 1.33 |

From the results in Table 1, it was found that the performance of the organic electroluminescence element using the iridium complex compound of the present invention was improved.

As is clear from the solubility test results below, Compound (D-1) and Compound (D-2) can be dissolved in cyclohexylbenzene at the same concentration as Compound (D-3) and Compound (D-4), and are excellent in solvent solubility like the Compounds (D-3) and (D-4).

### (Solubility test of iridium complex compound)

### [Example 7]

In a brown glass vial,3% by mass of Compound (D-1) and 97% by mass of cyclohexylbenzene (abbreviated as CHB) were mixed and the vial was sealed tightly with a cap. This was heated on a hot plate at 68°C and dissolved completely. After it was stored at room temperature and observed, it was kept in a uniform state without precipitation even after 210 days.

### [Example 8]

In a brown glass vial,3% by mass of Compound (D-2) and 97% by mass of cyclohexylbenzene were mixed and the vial was sealed tightly with a cap. This was heated on a hot plate at 68°C and dissolved completely. After it was stored at room temperature and observed, it was kept in a uniform state without precipitation even after 310 days.

### [Example 9]

In a brown glass vial, 3% by mass of a mixture of Compound (D-1) and Compound (D-6) at a mass ratio of 1:3 and 97% by mass of cyclohexylbenzene were mixed and sealed tightly with a cap. This was heated on a hot plate at 68°C and dissolved completely. After it was stored at room temperature and observed, it was kept in a uniform state without precipitation even after 336 days.

### [Example 10]

In a brown glass vial, 3% by mass of a mixture of Compound (D-1) and Compound (D-6) at a mass ratio of 1:1 and 97% by mass of cyclohexylbenzene were mixed and sealed tightly with a cap. This was heated on a hot plate at 68°C and dissolved completely. After it was stored at room temperature and observed, it was kept in a uniform state without precipitation even after 335 days.

### [Example 11]

In a brown glass vial, 3% by mass of a mixture of Compound (D-1) and Compound (D-6) at a mass ratio of 3:1 and 97% by mass of cyclohexylbenzene were mixed and sealed tightly with a cap. This was heated on a hot plate at 68°C and dissolved completely. After it was stored at room temperature and observed, it was kept in a uniform state without precipitation even after 336 days.

### [Comparative Example 7]

In a brown glass vial, 3% by mass of Compound (D-5) and 97% by mass of cyclohexylbenzene were mixed and sealed tightly with a cap. This was heated on a hot plate at 100°C and dissolved completely. After that, it was stored at room temperature, and precipitation was observed after only 5 minutes.

These test results are shown in Table 2.

**[Table 2]**

| | Iridium Complex Compiund (Mass Ratio) | Solvent | Concentration (% by Mass) | Temperature | Days of Uniformity |
|---|---|---|---|---|---|
| Example 7 | D-1 | CHB | 3 | Room Temperature | >210 |
| Example8 | D-2 | CHB | 3 | Room Temperature | >310 |
| Example9 | D-1:D-6 (3:1) | CHB | 3 | Room Temperature | >336 |
| Example 10 | D-1:D-6 (1:1) | CHB | 3 | Room Temperature | >335 |
| Example 11 | D-1:D-6 (1:3) | CHB | 3 | Room Temperature | >336 |
| Comparative Example 7 | D-5 | CHB | 3 | Room Temperature | 0 (Precipitated in 5 minutes) |

The results in Table 2 show that the iridium complex compound of the present invention has excellent solvent solubility and can stably exist as an ink for a long period of time without causing precipitation.

While the present invention has been described in detail using a specific embodiment, it should be apparent to those skilled in the art that various modifications can be made without departing from the scope of the present invention.

The present application is based on Japanese Patent Application No. 2021-087775 filed on May 25, 2021.

### Reference Signs List

- 1: substrate
- 2: anode
- 3: hole injection layer
- 4: hole transport layer
- 5: light-emitting layer
- 6: hole blocking layer
- 7: electron transport layer
- 8: electron injection layer
- 9: cathode
- 10: organic electroluminescent element

## Claims

1. An iridium complex compound denoted by a formula (1) below; 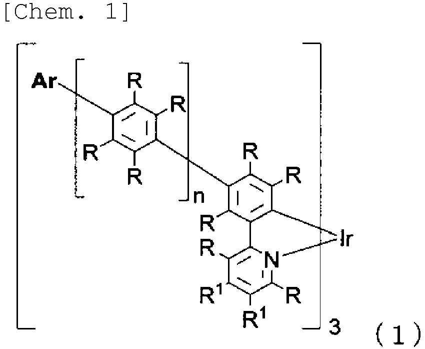 in the formula (1), Ir represents an iridium atom. n is 1 or 2. Ar is a structure represented by a formula (2) below; 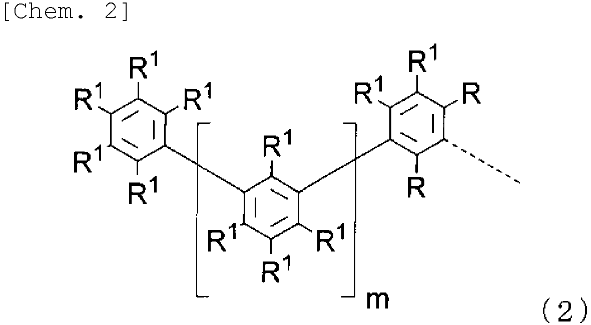 in the formula (2), a dashed line represents a bond of Ar in the formula (1). m is an integer from m=n+1 to n +5; substituents R in the formulas (1) and (2) are each independently a hydrogen atom, D or F; substituents R¹ in the formulas (1) and (2) are each independently a hydrogen atom, D, F, Cl, Br, I, -N(R')₂, - CN, -NO₂, -OH, -COOR', -C(=O)R', -C(=O)NR', -P(=O)(R')₂, - S(=O)R', -S(=O)₂R', -OS(=O)₂R', a linear, branched or cyclic alkyl group having 1 to 6 carbon atoms, a linear or branched alkoxy group having 1 to 4 carbon atoms, a linear, branched or cyclic alkylthio group having 1 to 4 carbon atoms, a linear or branched alkenyl group having 2 to 4 carbon atoms, a linear or branched alkynyl group having 2 to 4 carbon atoms, an aromatic group having 5 to 60 carbon atoms, a heteroaromatic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms . These groups may be substituted with one or more R' other than a hydrogen atom; each R' is independently a hydrogen atom, D, F, -CN, a linear, branched or cyclic alkyl group having 1 to 6 carbon atoms, a linear or branched alkenyl group having 2 to 4 carbon atoms, or a linear or branched alkynyl group having 2 to 4 carbon atoms.

2. The iridium complex compound according to Claim 1, wherein the substituents R and R¹ in the formulas (1) and (2) are a hydrogen atom or D.

3. An iridium complex compound-containing composition comprising the iridium complex compound according to Claim 1 or Claim 2.

4. The iridium complex compound-containing composition according to Claim 3, further comprising an iridium complex compound represented by a formula (3) below; 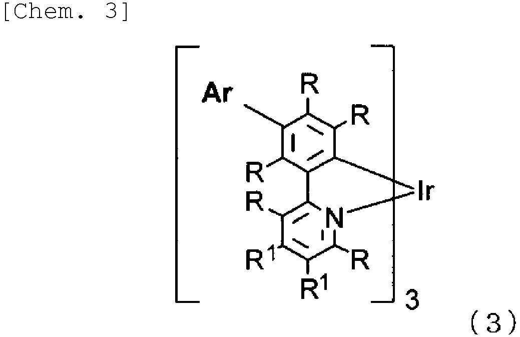 in the Formula (3), Ir represents an iridium atom. Ar is a structure represented by a formula (2) below; 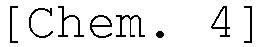 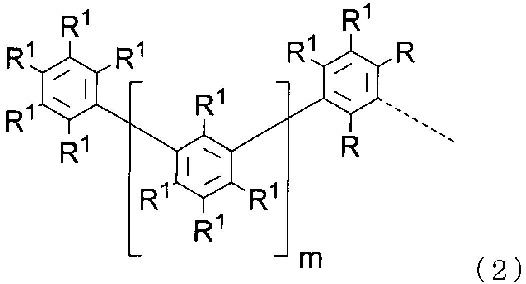 in the formula (2), a dashed line represents a bond of Ar in the formula (3). m is an integer from 1 to 6; substituents R in the formulas (3) and (2) are each independently a hydrogen atom, D or F; substituents R¹ in the formulas (3) and (2) are each independently a hydrogen atom, D, F, Cl, Br, I, -N(R')₂, - CN, -NO₂, -OH, -COOR', -C(=O)R', -C(=O)NR', -P(=O)(R')₂, - S(=O)R', -S(=O)₂R', -OS(=O)₂R', a linear, branched or cyclic alkyl group having 1 to 6 carbon atoms, a linear or branched alkoxy group having 1 to 4 carbon atoms, a linear, branched or cyclic alkylthio group having 1 to 4 carbon atoms, a linear or branched alkenyl groups having 2 to 4 carbon atoms, a linear or branched alkynyl group having 2 to 4 carbon atoms, an aromatic group having 5 to 60 carbon atoms, a heteroaromatic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms . These groups may be substituted with one or more R' other than a hydrogen atom; each R' is independently a hydrogen atom, D, F, -CN, a linear, branched or cyclic alkyl group having 1 to 6 carbon atoms, a linear or branched alkenyl group having 2 to 4 carbon atoms, or a linear or branched alkynyl group having 2 to 4 carbon atoms.

5. An organic electroluminescent element having at least an anode, a cathode, and at least one organic layer between the anode and the cathode on a substrate,
wherein at least one of the organic layers is a light-emitting layer, and
the light-emitting layer comprises the iridium complex compound according to Claim 1 or Claim 2.

6. The organic electroluminescence element according to Claim 5, wherein the light-emitting layer further comprises an iridium complex compound represented by a formula (3) below; 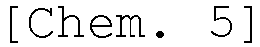 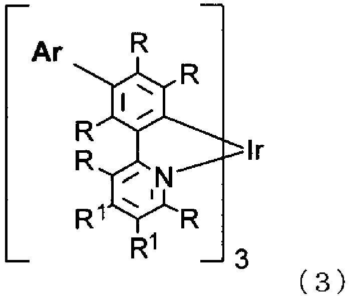 in the Formula (3), Ir represents an iridium atom. Ar is a structure represented by a formula (2) below; 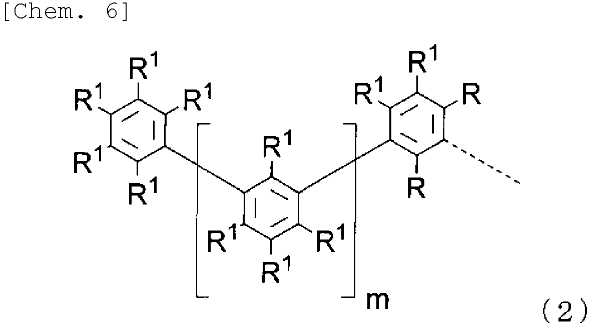 In the formula (2), a dashed line represents a bond of Ar in the formula (3). m is an integer from 1 to 6; substituents R in the formulas (3) and (2) are each independently a hydrogen atom, D or F; substituents R¹ in the formulas (3) and (2) are each independently a hydrogen atom, D, F, Cl, Br, I, -N(R')₂, - CN, -NO₂, -OH, -COOR', -C(=O)R', -C(=O)NR', -P(=O) (R')₂, - S(=O)R' , -S(=O)₂R', -OS(=O)₂R', a linear, branched or cyclic alkyl group having 1 to 6 carbon atoms, a linear or branched alkoxy group having 1 to 4 carbon atoms, a linear, branched or cyclic alkylthio group having 1 to 4 carbon atoms, a linear or branched alkenyl groups having 2 to 4 carbon atoms, a linear or branched alkynyl group having 2 to 4 carbon atoms, an aromatic group having 5 to 60 carbon atoms, a heteroaromatic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms . These groups may be substituted with one or more R' other than a hydrogen atom; each R' is independently a hydrogen atom, D, F, -CN, a linear, branched or cyclic alkyl group having 1 to 6 carbon atoms, a linear or branched alkenyl group having 2 to 4 carbon atoms, or a linear or branched alkynyl group having 2 to 4 carbon atoms.

7. The iridium complex compound-containing composition according to Claim 3 or Claim 4, further comprising a solvent.

8. A method for manufacturing an organic electroluminescence element having at least an anode, a cathode, and at least one organic layer between the anode and the cathode on a substrate,
wherein at least one of the organic layers is a light-emitting layer,
the light-emitting layer is formed by wet film-forming of the iridium complex compound-containing composition according to Claim 7.

9. An organic electroluminescence element manufactured by the method according to Claim 8.

10. A display device comprising the organic electroluminescent element according to Claim 6 or Claim 9.

11. An illumination device comprising the organic electroluminescent element according to Claim 6 or Claim 9.

## Patentansprüche

1. Iridiumkomplexverbindung mit der nachstehenden Formel (1); 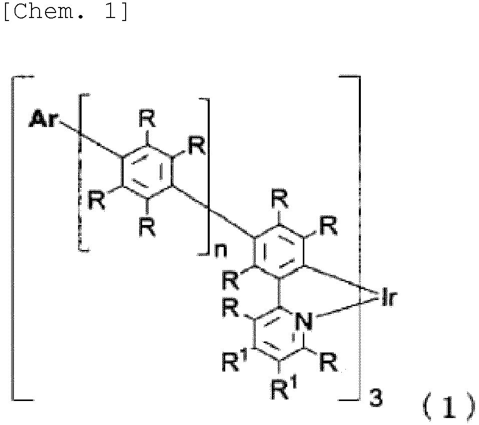
in der Formel (1) stellt Ir ein Iridiumatom dar. n ist 1 oder 2. Ar ist eine durch die nachstehende Formel (2) dargestellte Struktur; 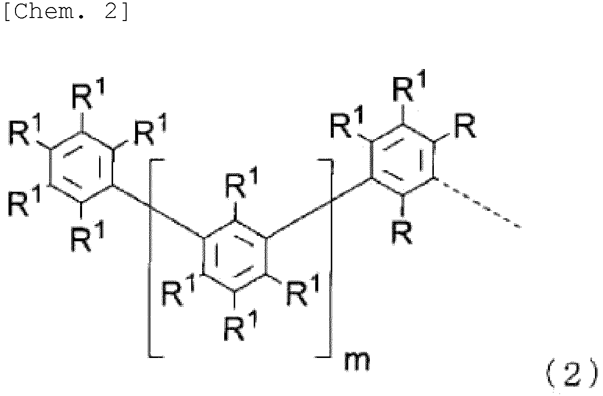
in der Formel (2) stellt eine gestrichelte Linie eine Bindung von Ar in der Formel (1) dar. n ist eine ganze Zahl von m=n+1 bis n+5;
Substituenten R in den Formeln (1) und (2) sind jeweils unabhängig ein Wasserstoffatom, D oder F;
Substituenten R¹ in den Formeln (1) und (2) sind jeweils unabhängig ein Wasserstoffatom, D, F, Cl, Br, I, -N(R')₂, -CN, -NO₂, -OH, -COOR', -C(=O)R', -C(=O)NR', -P(=O) (R')₂, -S(=O)R', -S(=O)₂R', -OS(=O)₂R', eine lineare, verzweigte oder cyclische Alkylgruppe mit 1 bis 6 Kohlenstoffatomen, eine lineare, verzweigte oder cyclische Alkoxygruppe mit 1 bis 4 Kohlenstoffatomen, eine lineare, verzweigte oder cyclische Alkylthiogruppe mit 1 bis 4 Kohlenstoffatomen, eine lineare, verzweigte oder cyclische Alkenylgruppe mit 2 bis 4 Kohlenstoffatomen, eine lineare, verzweigte oder cyclische Alkinylgruppe mit 2 bis 4 Kohlenstoffatomen, eine aromatische Gruppe mit 5 bis 60 Kohlenstoffatomen, eine heteroaromatische Gruppe mit 5 bis 60 Kohlenstoffatomen, eine Diarylaminogruppe mit 10 bis 40 Kohlenstoffatomen, eine Arylheteroarylaminogruppe mit 10 bis 40 Kohlenstoffatomen oder eine Diheteroarylaminogruppe mit 10 bis 40 Kohlenstoffatomen. Diese Gruppen können mit einem oder mehreren R' außer einem Wasserstoffatom substituiert sein;
jedes R' ist unabhängig ein Wasserstoffatom, D, F, -CN, eine lineare, verzweigte oder cyclische Alkylgruppe mit 1 bis 6 Kohlenstoffatomen, eine lineare, verzweigte oder cyclische Alkenylgruppe mit 2 bis 4 Kohlenstoffatomen oder eine lineare, verzweigte oder cyclische Alkinylgruppe mit 2 bis 4 Kohlenstoffatomen.

2. Iridiumkomplexverbindung gemäß Anspruch 1, wobei die Substituenten R und R¹ in den Formeln (1) und (2) ein Wasserstoffatom oder D sind.

3. Iridiumkomplexverbindung enthaltende Zusammensetzung, die die Iridiumkomplexverbindung gemäß Anspruch 1 oder Anspruch 2 umfasst.

4. Iridiumkomplexverbindung enthaltende Zusammensetzung gemäß Anspruch 3, ferner umfassend eine durch eine nachstehende Formel (3) dargestellte Iridiumkomplexverbindung; 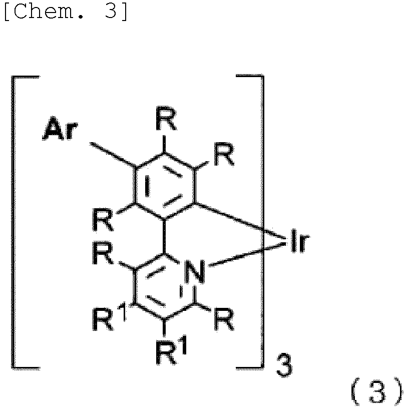
in der Formel (3) stellt Ir ein Iridiumatom dar. Ar ist eine durch eine nachstehende Formel (2) dargestellte Struktur; 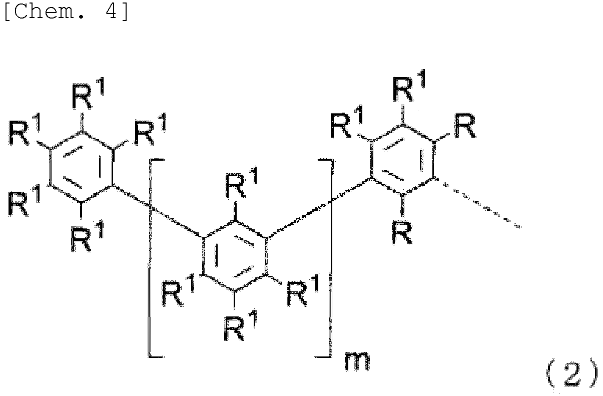
in der Formel (2) stellt eine gestrichelte Linie eine Bindung von Ar in der Formel (3) dar. n ist eine ganze Zahl von 1 bis 6;
R in den Formeln (3) und (2) sind jeweils unabhängig ein Wasserstoffatom, D oder F;
R¹ in den Formeln (3) und (2) sind jeweils unabhängig ein Wasserstoffatom, D, F, Cl, Br, I, -N(R')₂, -CN, -NO₂, -OH, -COOR', -C(=O)R', -C(=O)NR', -P(=O)(R')₂, -S(=O)R', -S(=O)₂R', -OS(=O)₂R', eine lineare, verzweigte oder cyclische Alkylgruppe mit 1 bis 6 Kohlenstoffatomen, eine lineare, verzweigte oder cyclische Alkoxygruppe mit 1 bis 4 Kohlenstoffatomen, eine lineare, verzweigte oder cyclische Alkylthiogruppe mit 1 bis 4 Kohlenstoffatomen, eine lineare, verzweigte oder cyclische Alkenylgruppe mit 2 bis 4 Kohlenstoffatomen, eine lineare, verzweigte oder cyclische Alkinylgruppe mit 2 bis 4 Kohlenstoffatomen, eine aromatische Gruppe mit 5 bis 60 Kohlenstoffatomen, eine heteroaromatische Gruppe mit 5 bis 60 Kohlenstoffatomen, eine Diarylaminogruppe mit 10 bis 40 Kohlenstoffatomen, eine Arylheteroarylaminogruppe mit 10 bis 40 Kohlenstoffatomen oder eine Diheteroarylaminogruppe mit 10 bis 40 Kohlenstoffatomen. Diese Gruppen können mit einem oder mehreren R' außer einem Wasserstoffatom substituiert sein;
jedes R' ist unabhängig ein Wasserstoffatom, D, F, -CN, eine lineare, verzweigte oder cyclische Alkylgruppe mit 1 bis 6 Kohlenstoffatomen, eine lineare, verzweigte oder cyclische Alkenylgruppe mit 2 bis 4 Kohlenstoffatomen oder eine lineare, verzweigte oder cyclische Alkinylgruppe mit 2 bis 4 Kohlenstoffatomen.

5. Organisches Elektrolumineszenzelement, die mindestens eine Anode, eine Kathode und mindestens eine organische Schicht zwischen der Anode und der Kathode auf einem Substrat aufweist,
wobei mindestens einer der organischen Schichten eine lichtemittierende Schicht ist und
die lichtemittierende Schicht die Iridiumkomplexverbindung gemäß Anspruch 1 oder Anspruch 2 umfasst.

6. Organisches Elektrolumineszenzelement gemäß Anspruch 5, wobei die lichtemittierende Schicht ferner eine durch eine nachstehende Formel (3) dargestellte Iridiumkomplexverbindung umfasst; 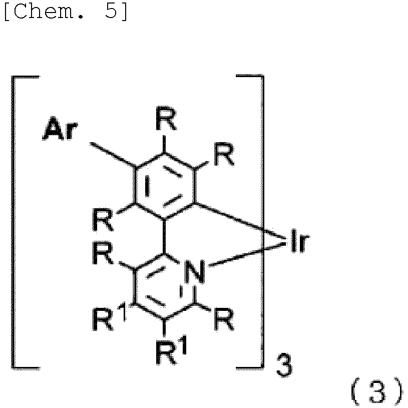
in der Formel (3) stellt Ir ein Iridiumatom dar. Ar ist eine durch eine nachstehende Formel (2) dargestellte Struktur; 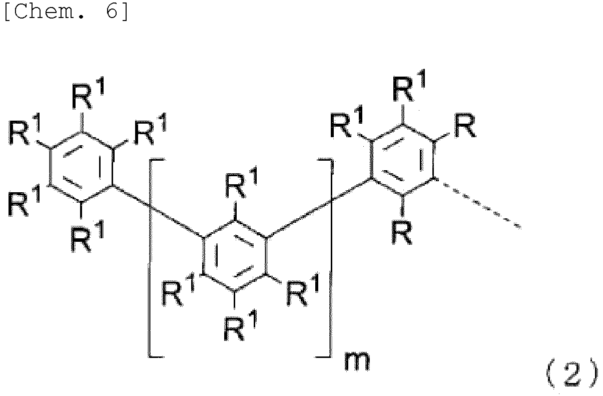
In der Formel (2) stellt eine gestrichelte Linie eine Bindung von Ar in der Formel (3) dar. m ist eine ganze Zahl von 1 bis 6;
R in den Formeln (3) und (2) sind jeweils unabhängig ein Wasserstoffatom, D oder F;
R¹ in den Formeln (3) und (2) sind jeweils unabhängig ein Wasserstoffatom, D, F, Cl, Br, I, -N(R')₂, -CN, -NO₂, -OH, -COOR', -C(=O)R', -C(=O)NR', -P(=O)(R')₂, -S(=O)R', -S(=O)₂R', -OS(=O)₂R', eine lineare, verzweigte oder cyclische Alkylgruppe mit 1 bis 6 Kohlenstoffatomen, eine lineare, verzweigte oder cyclische Alkoxygruppe mit 1 bis 4 Kohlenstoffatomen, eine lineare, verzweigte oder cyclische Alkylthiogruppe mit 1 bis 4 Kohlenstoffatomen, eine lineare, verzweigte oder cyclische Alkenylgruppe mit 2 bis 4 Kohlenstoffatomen, eine lineare, verzweigte oder cyclische Alkinylgruppe mit 2 bis 4 Kohlenstoffatomen, eine aromatische Gruppe mit 5 bis 60 Kohlenstoffatomen, eine heteroaromatische Gruppe mit 5 bis 60 Kohlenstoffatomen, eine Diarylaminogruppe mit 10 bis 40 Kohlenstoffatomen, eine Arylheteroarylaminogruppe mit 10 bis 40 Kohlenstoffatomen oder eine Diheteroarylaminogruppe mit 10 bis 40 Kohlenstoffatomen. Diese Gruppen können mit einem oder mehreren R' außer einem Wasserstoffatom substituiert sein;
jedes R' ist unabhängig ein Wasserstoffatom, D, F, -CN, eine lineare, verzweigte oder cyclische Alkylgruppe mit 1 bis 6 Kohlenstoffatomen, eine lineare, verzweigte oder cyclische Alkenylgruppe mit 2 bis 4 Kohlenstoffatomen oder eine lineare, verzweigte oder cyclische Alkinylgruppe mit 2 bis 4 Kohlenstoffatomen.

7. Iridiumkomplexverbindung enthaltende Zusammensetzung gemäß Anspruch 3 oder Anspruch 4, ferner umfassend ein Lösungsmittel.

8. Verfahren zur Herstellung eines organischen Elektrolumineszenzelements, das mindestens eine Anode, eine Kathode und mindestens eine organische Schicht zwischen der Anode und der Kathode auf einem Substrat aufweist,
wobei mindestens eine der organischen Schicht eine lichtemittierende Schicht ist,
die lichtemittierende Schicht durch Nassfilmbildung der Iridiumkomplexverbindung enthaltenden Zusammensetzung gemäß Anspruch 7 gebildet wird.

9. Organisches Elektrolumineszenzelement, hergestellt durch das Verfahren gemäß Anspruch 8.

10. Anzeigevorrichtung, umfassend das organische Elektrolumineszenzelement gemäß Anspruch 6 oder Anspruch 9.

11. Beleuchtungsvorrichtung, umfassend das Elektrolumineszenzelement gemäß Anspruch 6 oder Anspruch 9.

## Revendications

1. Composé complexe d'iridium désigné par une formule (1) ci-dessous ; 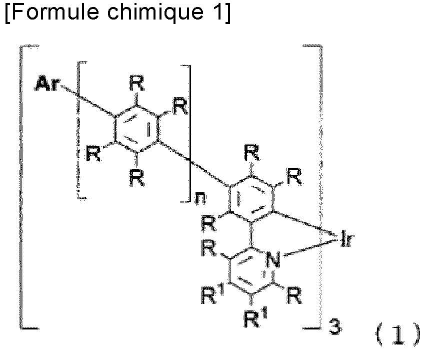
dans la formule (1), Ir représente un atome d'iridium ; n est égal à 1 ou 2. Ar est une structure représentée par une formule (2) ci-dessous ; 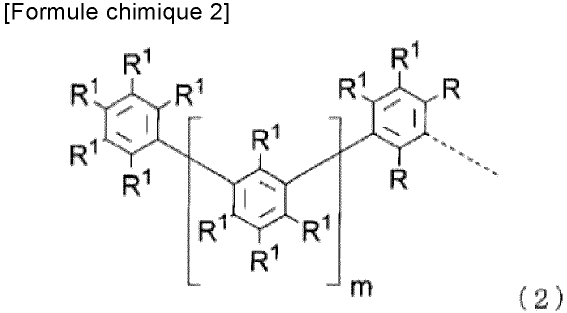
dans la formule (2), une ligne pointillée représente une liaison de Ar dans la formule (1) ; m est un nombre entier compris de m=n+1 à n+5 ; les substituants R dans les formules (1) et (2) sont chacun indépendamment un atome d'hydrogène, D ou F ;
les substituants R¹ dans les formules (1) et (2) sont chacun indépendamment un atome d'hydrogène, D, F, Cl, Br, I, -N(R')₂, -CN, -NO₂, -OH, -COOR', -C(=O)R', -C(=O)NR', -P(=O)(R')₂, -S(=O)R', -S(=O)₂R', -OS(=O)₂R', un groupe alkyle linéaire, ramifié ou cyclique, ayant de 1 à 6 atomes de carbone, un groupe alcoxy linéaire ou ramifié ayant de 1 à 4 atomes de carbone, un groupe alkylthio linéaire, ramifié ou cyclique ayant de 1 à 4 atomes de carbone, un groupe alcényle linéaire ou ramifié ayant de 2 à 4 atomes de carbone, un groupe alcynyle linéaire ou ramifié ayant de 2 à 4 atomes de carbone, un groupe aromatique ayant de 5 à 60 atomes de carbone, un groupe hétéroaromatique ayant de 5 à 60 atomes de carbone, un groupe diarylamino ayant de 10 à 40 atomes de carbone, un groupe arylhétéroarylamino ayant de 10 à 40 atomes de carbone, ou un groupe dihétéroarylamino ayant de 10 à 40 atomes de carbone ; ces groupes peuvent être substitués par un ou plusieurs R' autres qu'un atome d'hydrogène ;
chaque R' est indépendamment un atome d'hydrogène, D, F, -CN, un groupe alkyle linéaire, ramifié ou cyclique, ayant de 1 à 6 atomes de carbone, un groupe alcényle linéaire ou ramifié ayant de 2 à 4 atomes de carbone, ou un groupe alcynyle linéaire ou ramifié ayant de 2 à 4 atomes de carbone.

2. Composé complexe d'iridium selon la revendication 1, dans lequel les substituants R et R¹ dans les formules (1) et (2) sont un atome d'hydrogène ou D.

3. Composition contenant un composé complexe d'iridium comprenant le composé complexe d'iridium selon la revendication 1 ou la revendication 2.

4. Composition contenant un composé complexe d'iridium selon la revendication 3, comprenant en outre un composé complexe d'iridium représenté par une formule (3) ci-dessous ; 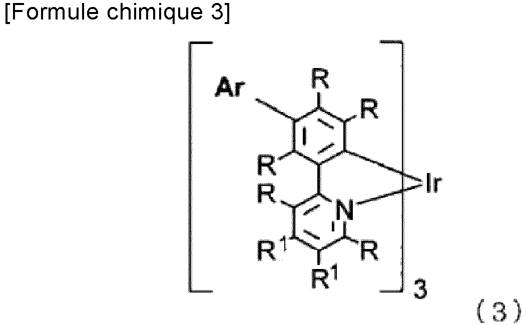
dans la Formule (3), Ir représente un atome d'iridium ; Ar est une structure représentée par une formule (2) ci-dessous ; 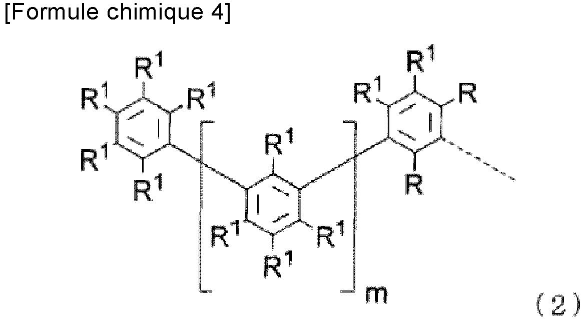
dans la formule (2), une ligne pointillée représente une liaison de Ar dans la formule (3) ; m est un nombre entier compris de 1 à 6 ;
les substituants R dans les formules (3) et (2) sont chacun indépendamment un atome d'hydrogène, D ou F ;
les substituants R¹ dans les formules (3) et (2) sont chacun indépendamment un atome d'hydrogène, D, F, Cl, Br, I, -N(R')₂, -CN, -NO₂, -OH, -COOR', -C(=O)R', -C(=O)NR', -P(=O)(R')₂, -S(=O)R', -S(=O)₂R', -OS(=O)₂R', un groupe alkyle linéaire, ramifié ou cyclique, ayant de 1 à 6 atomes de carbone, un groupe alcoxy linéaire ou ramifié ayant de 1 à 4 atomes de carbone, un groupe alkylthio linéaire, ramifié ou cyclique ayant de 1 à 4 atomes de carbone, un groupe alcényle linéaire ou ramifié ayant de 2 à 4 atomes de carbone, un groupe alcynyle linéaire ou ramifié ayant de 2 à 4 atomes de carbone, un groupe aromatique ayant de 5 à 60 atomes de carbone, un groupe hétéroaromatique ayant de 5 à 60 atomes de carbone, un groupe diarylamino ayant de 10 à 40 atomes de carbone, un groupe arylhétéroarylamino ayant de 10 à 40 atomes de carbone, ou un groupe dihétéroarylamino ayant de 10 à 40 atomes de carbone ; ces groupes peuvent être substitués par un ou plusieurs R' autres qu'un atome d'hydrogène ;
chaque R' est indépendamment un atome d'hydrogène, D, F, -CN, un groupe alkyle linéaire, ramifié ou cyclique, ayant de 1 à 6 atomes de carbone, un groupe alcényle linéaire ou ramifié ayant de 2 à 4 atomes de carbone, ou un groupe alcynyle linéaire ou ramifié ayant de 2 à 4 atomes de carbone.

5. Élément électroluminescent organique ayant au moins une anode, une cathode et au moins une couche organique entre l'anode et la cathode sur un substrat,
dans lequel au moins une des couches organiques est une couche électroluminescente, et
la couche électroluminescente comprend le composé complexe d'iridium selon la revendication 1 ou la revendication 2.

6. Élément électroluminescent organique selon la revendication 5, dans lequel la couche électroluminescente comprend en outre un composé complexe d'iridium représenté par une formule (3) ci-dessous ; 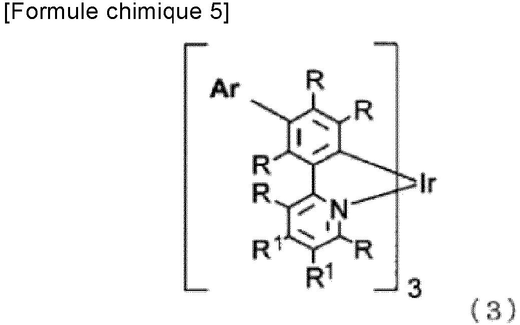
dans la Formule (3), Ir représente un atome d'iridium. Ar est une structure représentée par une formule (2) ci-dessous ; 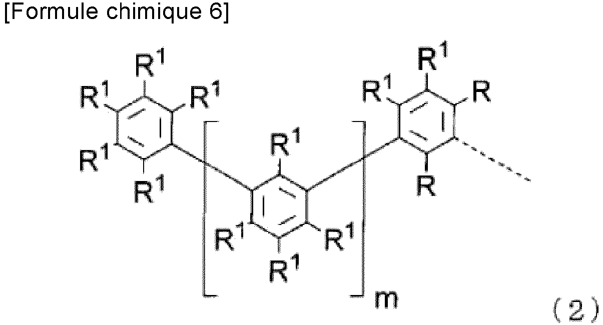
dans la formule (2), une ligne pointillée représente une liaison de Ar dans la formule (3) ; m est un nombre entier compris de 1 à 6 ;
les substituants R dans les formules (3) et (2) sont chacun indépendamment un atome d'hydrogène, D ou F ;
les substituants R¹ dans les formules (3) et (2) sont chacun indépendamment un atome d'hydrogène, D, F, Cl, Br, I, -N(R')₂, -CN, -NO₂, -OH, -COOR', -C(=O)R', - C(=O)NR', -P(=O)(R')₂, -S(=O)R', -S(=O)₂R', -OS(=O)₂R', un groupe alkyle linéaire, ramifié ou cyclique, ayant de 1 à 6 atomes de carbone, un groupe alcoxy linéaire ou ramifié ayant de 1 à 4 atomes de carbone, un groupe alkylthio linéaire, ramifié ou cyclique ayant de 1 à 4 atomes de carbone, un groupe alcényle linéaire ou ramifié ayant de 2 à 4 atomes de carbone, un groupe alcynyle linéaire ou ramifié ayant de 2 à 4 atomes de carbone, un groupe aromatique ayant de 5 à 60 atomes de carbone, un groupe hétéroaromatique ayant de 5 à 60 atomes de carbone, un groupe diarylamino ayant de 10 à 40 atomes de carbone, un groupe arylhétéroarylamino ayant de 10 à 40 atomes de carbone, ou un groupe dihétéroarylamino ayant de 10 à 40 atomes de carbone ; ces groupes peuvent être substitués par un ou plusieurs R' autres qu'un atome d'hydrogène ;
chaque R' est indépendamment un atome d'hydrogène, D, F, -CN, un groupe alkyle linéaire, ramifié ou cyclique, ayant de 1 à 6 atomes de carbone, un groupe alcényle linéaire ou ramifié ayant de 2 à 4 atomes de carbone, ou un groupe alcynyle linéaire ou ramifié ayant de 2 à 4 atomes de carbone.

7. Composition contenant un composé complexe d'iridium selon la revendication 3 ou la revendication 4, comprenant en outre un solvant.

8. Procédé de fabrication d'un élément électroluminescent organique ayant au moins une anode, une cathode et au moins une couche organique entre l'anode et la cathode sur un substrat,
dans lequel au moins une des couches organiques est une couche électroluminescente,
la couche électroluminescente est formée par formation de film humide de la composition contenant un composé complexe d'iridium selon la revendication 7.

9. Élément électroluminescent organique fabriqué par le procédé selon la revendication 8.

10. Dispositif d'affichage comprenant l'élément électroluminescent organique selon la revendication 6 ou la revendication 9.

11. Dispositif d'éclairage comprenant l'élément électroluminescent organique selon la revendication 6 ou la revendication 9.
